# EUROPEAN PATENT APPLICATION

(11) **EP 1 901 292 A2**
(43) Date of publication of application: **19.03.2008**
(21) Application number: 07017544.3
(22) Date of filing: 07.09.2007
(51) Int. Cl.: G11B 20/00, H03M 7/30

(54) **Fusion memory device and method**

(30) Priority: 08.09.2006 KR 20060087076
(71) Applicant: Samsung Electronics Co., Ltd, Suwon-si, Gyeonggi-do (KR)
(72) Inventor: Oh, Sung Jo, Suwon-si, Gyeonggi-do (KR)
(74) Representative: Boakes, Jason Carrington

(57) **Abstract**

A fusion memory device and method that is capable of storing binary data in a compressed format and reading out the compressed binary data in a decompressed format is provided. The fusion memory device includes a main memory for storing data in a compressed format; a secondary memory for buffering binary data to be written within and read from the main memory; and a memory controller having a pair of compressor and decompressor. The memory controller controlling the secondary memory to buffer the binary data downloaded from a host device and the compressor compressing the binary data buffered with the secondary memory in a writing mode. The memory controller controlling the secondary memory to buffer the binary data read out from the main memory within the secondary memory and the decompressor decompressing the binary data buffered within the secondary memory in a reading mode.

## Description

### BACKGROUND OF THE INVENTION

### 1. Field of the Invention

The present invention relates generally to a fusion memory and, in particular, to a fusion memory device and a method that is capable of storing binary data in a compressed format and reading out the compressed binary data in a decompressed format.

### 2. Description of the Related Art

A fusion memory is a device integrating different types of memories and logics on a single chip. The fusion memory is advantageous in that system specific software can be provided with the system memory. With the combination of a high density memory, logic, and software availability, the fusion memory is expected to lead the mobile device market facing new demands in a digital convergence era.

Mobile devices such as cellular phones integrate different features such as digital broadcast receiver, camera, MP3 player, and Bluetooth. Such functional convergence of a mobile device increases the size of the system software, firmware, and user data, requiring large memory space. Thus, the fusion memory should be designed for efficiently storing the large binary data.

In the conventional fusion memory, however, the system software, firmware, and user data are stored in the form of raw binary data and results in a memory shortage. Accordingly, there has been a need for efficient memory management technology with a binary data compression/decompression logic.

### SUMMARY OF THE INVENTION

The present invention has been made in an effort to solve the above problems. The present invention provides a fusion memory device and a method that is capable of storing binary data in a compressed format.

The present invention also provides a fusion memory device and a method that is capable of recovering original binary data from a compressed data stored in the fusion memory.

In accordance with an aspect of the present invention, a fusion memory device of the present invention includes a main memory for storing data in a compressed format; a secondary memory for buffering binary data to be written within and read from the main memory; and a memory controller having a pair of compressor and decompressor and controlling, in a writing mode, the secondary memory to buffer the binary data downloaded from a host device and the compressor to compress the binary data buffered with the secondary memory, and controlling, in a reading mode, the secondary memory to buffer the binary data read out from the main memory within the secondary memory and the decompressor to decompress the binary data buffered within the secondary memory.

In accordance with another aspect of the present invention, a fusion memory device of the present invention includes a main memory including a pseudo NOR mapping area and a host memory mapping area; a secondary memory for buffering binary data downloaded from a host device and read out from the main memory; and a memory controller for controlling the main memory and secondary memory., in a writing mode, to read out the downloaded binary data from the secondary memory and to write the read binary data within the main memory via a NAND interface and, in a reading mode, to read out the binary data from main memory to be accessed by the host device, wherein the binary data stored within the host mapping region of the main memory is read out to the host device via the NAND interface, and the binary data stored within the pseudo NOR mapping area is read out via the NAND interface and buffered within the secondary memory with an address converted for the host device to read out the buffered binary data from the secondary memory via the NOR interface.

In accordance with another aspect of the present invention, a fusion memory device of the present invention includes a main memory including a pseudo NOR mapping area and a host memory mapping area for storing data compressed depending on data types; a secondary memory for buffering the data to be written within or read out from the main memory; and a memory controller including a pair of compressor and decompressor, the memory controller controlling, in a writing mode, to buffer the binary data downloaded from a host device within the secondary memory, compress the buffered binary data through use of the compressor, and write the compressed binary data with a corresponding mapping area of the main memory via a NAND interface; and controlling, in a reading mode, to read out the binary data from the main memory via the NAND interface and buffer the read data within the secondary memory, recover the binary data from a compressed format through use of the decompressor, output the data derived from the host memory mapping area to the host interface via the NAND interface, convert an address of the data derived from the pseudo NOR mapping area for allowing NOR interface access, and buffer the data within the secondary memory with the converted address such that the host device can read out the data from the secondary memory via the NOR interface.

In accordance with another aspect of the present invention, a device includes a host device and a fusion memory device. The fusion memory device includes a main memory including a pseudo NOR mapping area and a host memory mapping area, a secondary memory for buffering binary data to be read from and written with the main memory, and a memory controller including a pair of compressor and decompressor and controlling, in a writing mode, the secondary memory to buffer the binary data downloaded from the host device and the compressor to compressing the binary data buffered with the secondary memory, and controlling, in a reading mode, the secondary memory to buffer the binary data read out from the main memory within the secondary memory and the decompressor to decompress the binary data buffered within the secondary memory. The host device includes a host memory for storing the data read out from the main memory, and a host controller for controlling the host device to transmit control information including address information to the fusion memory device, write, in the writing mode, the binary data within the main memory via the NAND interface, read, in the reading mode, the binary data from the host memory mapping area of the main memory via the NAND interface and from the pseudo NOR mapping area via the NOR interface.

In accordance with another aspect of the present invention, a method for accessing a fusion memory device including a main memory and a secondary memory for buffering binary data to be read from and written to the main memory includes buffering, in a writing mode, binary data downloaded from a host device within the secondary memory; compressing the binary data; writing the compressed binary data read out from the secondary memory within the main memory; buffering, in a reading mode, the compressed binary data read out from the main memory within the secondary memory; decompressing the compressed binary data; and outputting the binary data read out from the secondary memory to the host device.

In accordance with another aspect of the present invention, a method for accessing a fusion memory device including a main memory having a pseudo NOR mapping area and a host memory mapping area and a secondary memory for buffering binary data to be read from and written to the main memory includes buffering, in a writing mode, binary data downloaded from a host device within the secondary memory; writing the binary memory read out from the secondary memory within the main memory via a NAND interface; and reading out, in a reading mode, the binary data from the main memory to the host device, the binary memory stored within the host memory mapping region being read out via the NAND interface, and the binary memory stored within the pseudo NOR mapping area being read out via the NAND interface, an address of the binary data read out from the pseudo NOR mapping area being converted and buffered within the secondary memory with the secondary memory such that the host device can read out the binary memory buffered within the secondary memory via NOR interface with reference to the converted address.

In accordance with another aspect of the present invention, a method for accessing a fusion memory device including a main memory having a pseudo NOR mapping area and a host memory mapping area and a secondary memory for buffering binary data to be read from and written to the main memory includes buffering, in a writing mode, binary data download from a host device within the secondary memory, compressing the binary data, and writing the compressed binary data within one of the mapping areas of the main memory via a NAND interface; and reading out, in a reading mode, compressed binary data from the main memory, buffering the compressed binary data within the secondary memory, decompressing the compressed binary data, determining whether the decompressed binary data is read out from the host memory mapping area, outputting, when the decompressed binary data is read out from the host memory mapping area, the decompressed to the host device via the NAND interface, determining, when the decompressed binary data is read out from the pseudo NOR mapping area, converting, when the decompressed binary data is read out from the pseudo NOR mapping area, an address of the decompressed binary data into a NOR interface accessible address, and notifying the NOR interface accessible address to the host device.

### BRIEF DESCRIPTION OF THE DRAWINGS

The above and other objects, features and advantages of the present invention will become more apparent from the following detailed description when taken in conjunction with the accompanying drawings, in which:
FIG. 1 is a schematic block diagram illustrating a fusion memory device according to an exemplary embodiment of the present invention;
FIG. 2 is a block diagram illustrating a configuration of a fusion memory and host device according to an exemplary embodiment of the present invention;
FIG. 3 is a block diagram illustrating read/write operations of a fusion memory according to an exemplary embodiment of the present invention;
FIG. 4 is a block diagram illustrating read/write operations of a fusion memory device according to another exemplary embodiment of the present invention;
FIG. 5 is a block diagram illustrating an interoperation between a host device and a fusion memory device according to an exemplary embodiment of the present invention;
FIG. 6 is a block diagram illustrating how to store a code within a fusion memory device according to an exemplary embodiment of the present invention;
FIG. 7 is a block diagram illustrating how to read a code stored within a pseudo NOR mapping area of a fusion memory device according to an exemplary embodiment of the present invention;
FIG. 8 is a block diagram illustrating how to read a code stored within a RAM mapping area of a fusion memory device according to an exemplary embodiment of the present invention;
FIG. 9 is a block diagram illustrating how to read/write a code within a user data region of a fusion memory device according to an exemplary embodiment of the present invention;
FIG. 10 is a block diagram illustrating a configuration of a fusion memory device according to an exemplary embodiment of the present invention;
FIG 11 is a block diagram illustrating an interoperation between the fusion memory device of FIG. 10 and a host device according to an exemplary embodiment of the present invention;
FIG. 12 is a block diagram illustrating how a code is stored within the system data region of the main memory of a fusion memory device according to an exemplary embodiment of the present invention;
FIG. 13 is a block diagram illustrating how a code is read from the pseudo NOR mapping area of the main memory of a fusion memory device according to an exemplary embodiment of the present invention;_
FIG. 14 is a block diagram illustrating how a code is read out from the RAM mapping area of the main memory of a fusion memory device according to an exemplary embodiment of the present invention;_
FIG 15 is a block diagram illustrating how a user data is written within the user data region of the main memory of a fusion memory device according to an exemplary embodiment of the present invention;
FIG. 16 is a block diagram illustrating how a user data is read out from the user data region of the main memory of a fusion memory device according to an exemplary embodiment of the present invention;_
FIG. 17 is a diagram illustrating an operation of the information detector of FIGS. 10 and 11;-FIG. 18 is a schematic view illustrating a data format used in a fusion memory device according to an exemplary embodiment of the present invention;
FIG. 19 is a block diagram illustrating a compressor of a fusion memory device for compressing binary data according to an exemplary embodiment of the present invention;
FIG. 20 is a diagram illustrating how a distance and difference between a range block and domain blocks in a searching range are compared by the coder 540 of FIG. 19;
FIG. 21 is a block diagram illustrating a decompressor of a fusion memory device for decompressing compressed binary data according to an exemplary embodiment of the present invention;
FIG. 22 is a diagram illustrating how compressed data is decompressed by the decompressor of the fusion memory device according to an exemplary embodiment of the present invention;
FIG. 23 is a block diagram illustrating a configuration of a compressor of a fusion memory device according to an exemplary embodiment of the present invention;
FIG. 24 is a flowchart diagram illustrating an operation of the searcher of FIG. 23;
FIG. 25 is a flowchart illustrating a binary data compression operation of the coder of FIG. 23;
FIG. 26 is a block diagram illustrating a configuration of a decompressor of a fusion memory device according to an exemplary embodiment of the present invention; and
FIG. 27 is a flowchart illustrating a decompression operation of the decoder of FIG. 26.

### DETAILED DESCRIPTION OF THE PREFERRED EMBODIMENTS

Preferred embodiments of the present invention are described with reference to the accompanying drawings in detail. The same reference numbers are used throughout the drawings to refer to the same or like parts. Detailed descriptions of well-known functions and structures incorporated herein may be omitted to avoid obscuring the subject matter of the present invention.

Types of memory and units of data processing and compression/decompression are provided to enable a clear and consistent understanding of the detailed description and the claims. Unless otherwise noted, terms are to be understood according conventional usage by those skilled in the relevant art.

In the following preferred embodiments, the term "fusion memory" means a memory device integrated with different types of memory and non-memory with specific logics on a single chip in addition to a main memory. The term "code" means a unit of binary data by which system software and firmware are stored within the main memory of the fusion memory device. The term "user data" means all kinds of data, except for the codes, stored within the main memory of the fusion memory device. The term "binary data" represents all kinds of data including the codes and user data stored within the main memory of the fusion memory device. The term "memory controller" indicates a component for compressing/decompressing the binary data and controlling an access to the binary data stored within main memory with a NAND or NOR interface.

The main memory of the fusion memory device is provided with processing an execution space and storage space for executing and storing the codes (software and firmware) and user data. In an embodiment of the present invention, the fusion memory device is provided with logic for compressing and storing the binary data including the software, firmware, and user data within the main memory and decompressing the compressed data to be output in the form of binary data. The fusion memory device enables large amount of binary data greater than physical storage space of the memory to be stored and loaded.

In an embodiment of the present invention, the fusion memory device is provided with a compressor/decompressor unit embedded in the main memory so as to efficiently manage the storage space with fast compression/decompression operations.

The fusion memory device according to an embodiment of the present invention is provided with a storage region accessed through a NOR interface and a storage region accessed through a NAND interface such that the fusion memory device can access the binary data store in the different memory regions through the NAND or NOR interface under the control of an external device.

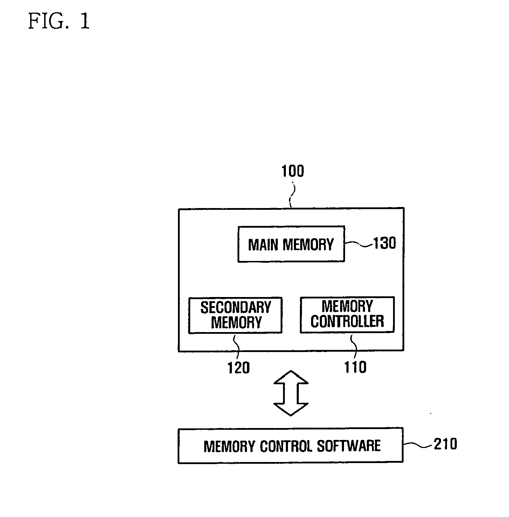

FIG. 1 is a schematic block diagram illustrating a fusion memory device according to an exemplary embodiment of the present invention.

As described above, a fusion memory device is the memory device integrated with the main memory, secondary memory, non-memory, and/or a logic on a single chip. The logic can be a pure logic, a Central Processing Unit (CPU), a Microprocessing Unit (MPU), or a combination thereof. In the embodiments of the present invention, it is assumed that a memory controller is provided with a compressor/decompressor implemented in the form of a logic.

The fusion memory can be implemented with a combination of different types of memories. OneNAND memory is a well-known fusion memory commercialized by Samsung Electronics Co. Ltd. OneNAND memory is implemented by integrating a high density NAND flash cell and a high speed static random access memory (SRAM) with a logic circuit on a signal chip. OneNAND memory has advantages of a large storage, high-speed data read/write capability of NAND flash memory, and byte access capability of NOR flash memory. OneNAND memory has a sustained read and write speed faster than the NAND and NOR memories while maintaining a capacity data storage. With these advantages, OneNAND memory is expected to be used in a growing number of applications including mobile handsets, computers, digital cameras, and digital broadcast receivers.

In the following embodiments, a fusion memory device is assumed as OneNAND device in which a memory controller is provided with a compressor/decompressor for efficiently managing the memory by compressing/decompressing the binary data. However, the present invention is not limited to OneNAND device, but can be applied to all kinds of fusion memory devices. In the following embodiments, it is assumed that the host device of a fusion memory device is a mobile terminal. The mobile terminal can be any of electronic devices having information processing functions such as communication and multimedia functions.

Referring to FIG. 1, a fusion memory device 100 includes a main memory 130, a secondary memory 120, and a memory controller 110. When a fusion memory is implemented as OneNAND memory, the main memory 130 is a NAND flash cell array, the secondary memory 120 is an SRAM, and the memory controller 110 is a logic for compressing/decompressing binary data. The functions of the memory controller 110 may be executed by a system software of with the host device. Reference numeral 210 denotes a memory control software for controlling the operation of the fusion memory device 100 as a part of the system control unit. The memory controller 110 operates under the control of the memory control software 210.

The main memory 130 is structured as a NAND flash cell array for storing binary data and divided into a system data region and a user data region. The system data region can be provided with a pseudo NOR mapping area and a RAM mapping area. The system data region is used for storing the codes of the system software and firmware, and the user data region is used for storing user data. The secondary memory 120 is used for converting the binary data of the pseudo NOR mapping area and acts as a buffer of the main memory 130. The memory controller 110 compresses the input binary data and stores the compressed data within the main memory 130. Also, the memory controller 110 reads out the binary data by decompressing the compressed data from the main memory 130. The memory controller 110 is provided with a compressor/decompressor for compressing the binary data and decompressing the compressed binary data.

As described above, the binary data include the codes representing the system software and firmware or the user data. For a mobile terminal equipped with the fusion memory device 100, the memory controller 110 can be configured such that the compressor/decompressor performs compression/decompression as following.

The code can be any of text code, read only (RO) data, read and writable (RW) data, and resource. The text code is a pure program code, the RO data is a constant data of which value cannot be changeable during the execution, the RW data is a data of which value can be changeable during the execution, and the resource can be any of a font, background image, bell sound, and string for use in the mobile terminal. The text code can be a program instruction, and the RO, RW, and resource can be application data. The compression ranges of the program instruction and application data are distinguishably set according to their characteristics and managed in the form of a table for use in data compression/decompression process.

The user data is data generated while the mobile terminal executes applications. The user data includes a phonebook, short message service (SMS) message, multimedia message service (MMS) message, e-mail message service (EMS) message, personal information management (PIM) data, call log, and multimedia data including still picture, motion picture, and audio data. By storing the user data in a compressed format, the storage efficiency of the main memory 130 can be improved. The user data compression can be performed with different compression schemes showing a highest compression efficiency according to the types of the user data.

By implementing the fusion memory device 100 with the compressor/decompressor within the memory controller 110, the main memory 130 can be efficiently managed. Since the main memory 130 stored the binary data in the compressed format, it is possible to conserve the storage space of both the system data region and the user data region of the main memory 130. In other words, the system data region can store the more codes or the conserved space can be used for storing the user data.

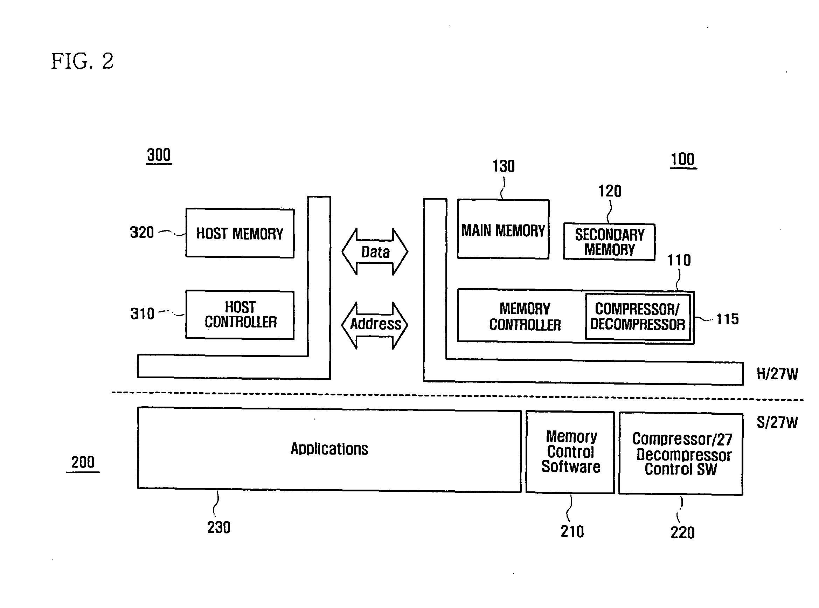

FIG. 2 is a block diagram illustrating a configuration of a fusion memory and host device according to an exemplary embodiment of the present invention.

Referring to FIG. 2, a host device 300 includes a host controller 310 and a host memory 320. Here, the host device 300 is a mobile terminal. Host controller 310 becomes a terminal controller for controlling general operations of a mobile terminal, and the host memory 320 stored the binary data of the host device 300. The host memory 320 operates as a working memory of the host device 300.

A software module 200 is provided with software of the host device 300 that includes applications 230, memory control software 210 for controlling the operations of the fusion memory device 100, and compression/decompression control software 220 for controlling the compression/decompression of the binary data stored in the fusion memory device 100.

As shown in FIG. 2, the memory controller 110 is provided with a compressor/decompression module 115 for performing compression on the binary data to be stored within the main memory 130 and decompression on the compressed to be read out. The host controller 310 is coupled with the fusion memory 100 through address lines, data lines, and command lines, and the memory control software 210 controls the operations of the fusion memory 100 in cooperation with a control software, i.e. the compressor/decompressor control software 220. In a case that a specific content is modified, the function of the application 230 is restricted, the memory controller 110 and memory control software 210 are processing the specific tasks and returns the processing result to the applications 230. The binary data can be stored after modified in a specific format. The specific format is determined by an embedded file system. In this embodiment, the user data can be stored in accordance with the file system. The binary data stored in the main memory 130 can be the compressed data.

The main memory 130 of the fusion memory device 100 can be a NAND flash memory. The binary data are stored within the NAND flash memory in unit of page and erased from the NAND flash memory in unit of block. The page and block can be set with respective sizes (for example, 512 bytes per page and 32 pages per block). The NAND flash memory should be erased before storing the binary data. Accordingly, the memory controller 110 erases the address region of the main memory 130 in unit of block and the writes the binary data in unit of page.

The memory 130 of the fusion memory device 100 consists of a system data region and a user data region, and the system data region is divided into the pseudo NOR mapping area and the RAM mapping area. Here, the host controller 310 can access the binary data stored in the system data region through a NOR interface or NAND interface. To write the binary data into the system data region of the main memory 130, the memory controller 110 uses the NAND interface. The binary data stored within the pseudo NOR mapping area of the system data region is read through the NOR interface and the binary data stored within the RAM mapping area of the system data region is read through the NAND interface.

The NOR interface allows accessing the binary data in unit of byte, and the NAND interface allows accessing the binary data in unit of page. The fusion memory device 100 performs compression on the binary data to be stored within the main memory 130 and performs decompression on the compressed data to be read out.

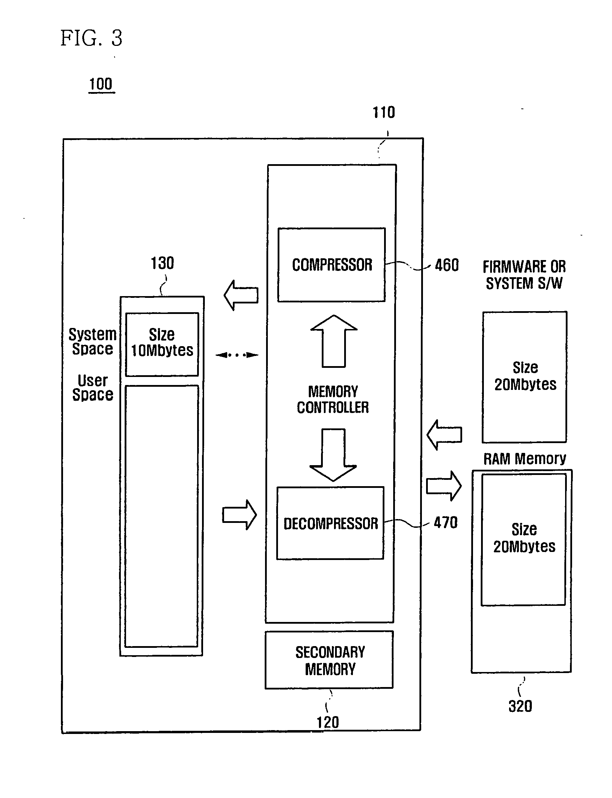

FIG. 3 is a block diagram illustrating read/write operations of a fusion memory according to an exemplary embodiment of the present invention. The fusion memory device 100 is provided with a compressor 460 and a decompressor 470 composed of logics. In FIG. 3, the compressor 460 operates at a compression rate of 2:1.

Referring to FIG. 3, the memory controller 110 controls the compressor to compress the binary data to be stored within the system data region of the main memory 130 and controls the decompressor to decompress the compressed code to be read out from the main memory 130. The codes are compressed by the compressor 460 of the memory controller 110 and then stored within the system data region of the main memory 130. Also, the compressed code stored within the main memory 130 are decompressed by the decompressor 470 and then read out to be executed.

In transferring the codes (for example, the system software or firmware) stored in the host memory 320 to the main memory 130, the memory controller 110 accesses the target code stored within the host memory 320, compresses the code read out from the host memory 320, and stores the compressed code within the system data region of the main memory 130. In FIG. 3, it is depicted that the code of 20Mbytes is compressed into 10Mbytes by the compressor 460.

In loading the code stored in the system data region of the main memory 130, the memory controller 110 accesses the compressed code stored in the system data region of the main memory 130, decompresses the compressed code to recover the raw code through use of the decompressor 470, and loads the recovered code onto the host memory 320. In FIG. 3, it is depicted that the compressed code of 10Mbytes is recovered to 20Mbytes by the decompressor 470.

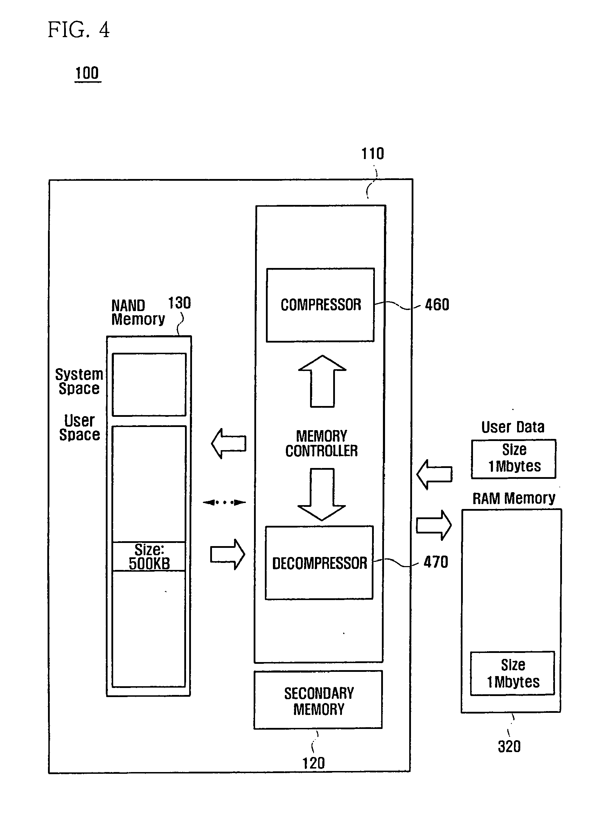

FIG. 4 is a block diagram illustrating read/write operations of a fusion memory device according to another exemplary embodiment of the present invention. As in FIG. 3, the fusion memory device 100 is provided with the compressor 460 and decompressor 470 composed of the logics, and the compressor 460 operates at the compression rate of 2:1.

In transferring the user data stored within the host memory 320 to the main memory 130 of the fusion memory device 100, the memory controller 110 accesses read out the binary data stored in the host memory 320, compress the binary data read out from the host memory 320, and stores the compressed data within the user data region of the main memory 130.

In reading out the user data from the user data region of the main memory 130, the memory controller 110 accesses the compressed user data stored in the user data region of the main memory 130, decompresses the compressed user data to recover the raw user data through use of the decompressor 470, and stores the recovered user data within the host memory 320.

As described above, the fusion memory device 100 compresses the user data and then stores the user data within the user data region of the main memory 130 in the compressed format. When it is required to load the user data, the fusion memory device 100 reads out the compressed user data from the user data region of the main memory 130, performs decompression on the compressed user data to recover the raw user data, and loads the user data on the host memory 320.

As depicted in FIGS. 3 and 4, when the fusion memory device 100 operates to store the binary data (codes and/or user data), the memory controller 110 compresses the binary data and stores the compressed data within the system and user data regions. The compressed data are decompressed as they are accessed. By storing the data in the compressed format, the storage space of the main memory 130 can be efficiently managed. The codes and user data are processed by different compressor and decompressor according to their attributes. The fusion memory device can be provided with a pair of code compressor and decompressor that operate at a high compression/decompression rate with the codes and a pair of data compressor and decompressor that operate at a high compression/decompression rate with the user data. The pair of compressor 460 and decompressor 470 can be implemented with a code compression/decompression modules and a data compression/decompression modules. The pair of compressor 460 and decompressor 470 can be implemented with at least one pair of compression and decompression modules, respectively. Also, each compression module/decompression module can be implemented with at least one pair of compression/decompression entity responsible for processing specific types of codes or data.

The host controller 310 can be configured to access the binary data stored within the fusion memory device 100 through the NOR interface and the NAND interface. Accordingly, the host controller 310 can control the fusion memory device 100 to operate as the program memory of the host device 300 and the data memory for storing the user data requiring large storage space. The memory controller 110 accesses the codes stored within the system data region through the NAND interface and NOR interface under the control of the host controller 310. In the codes to be stored within the pseudo NOR mapping area of the system data region, the memory controller 110 stores the codes downloaded from the host controller 310 within the pseudo NOR mapping region of the system data region of the main memory 130. In accessing the codes stored within the pseudo NOR mapping area, the memory controller 110 reads the code stored in the pseudo NOR mapping area of the main memory 130 through the NAND interface and converts the address of the code to be read through the NOR interface. Sequentially, the memory controller 110 buffers the code within the secondary memory 120 and reports this to the host controller 310. Accordingly, the host controller 310 accesses the code stored in the second memory 120 through the NOR interface.

In storing the code within the RAM mapping area, the memory controller 110 stores the coded downloaded from the host controller 310 within the RAM mapping area of the system data region of the main memory 130. In accessing the code stored within the RAM mapping area, the memory controller 110 reads the code stored in the RAM mapping area of the main memory through the NAND interface such that the host controller 310 stores the code read by the memory controller 110 within the host memory 320 through the NAND interface.

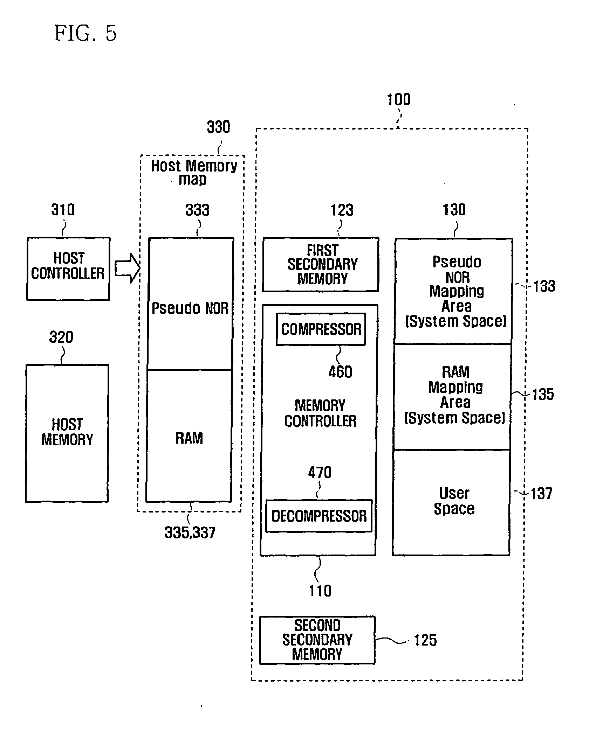

FIG. 5 is a block diagram illustrating an interoperation between a host device and a fusion memory device according to an exemplary embodiment of the present invention.

Referring to FIG. 5, the host controller 310 controls general operations of the host device 300 shown in FIG. 2. The host controller 310 is provided with a host software module for controlling the read and write operations of the fusion memory device 100. The host memory 320 operates as a working memory of the host controller 310. The host memory 320 can be implemented with a RAM. The host controller 310 uses a host memory map 330 for accessing data stored within the fusion memory device 100.

The host memory map 330 is provided with a RAM region having a system and user data regions 335 and 337 for the system and user data region of the host memory 320, and a pseudo NOR region 333 for the pseudo NOR mapping area of the system data region. Here, the RAM region 335 and 337 is a real space for use when the host controller 310 accesses the RAM mapping area 135 and the user data region 137 of the main memory 130 of the fusion memory device 100, and the pseudo NOR region 333 is a virtual space for use when the host controller 310 accesses the pseudo NOR mapping area 133 of the main memory 130 of the fusion memory device 100. The host memory map 330 includes the pseudo NOR region 333 for accessing the pseudo NOR mapping area 133 of the fusion memory 100 and the RAM region 335 and 337 of the physical host memory 320.

The fusion memory device 100 includes a memory controller 110, a first secondary memory 123, a second secondary memory 125, and a main memory 130. The memory controller 110 accesses the binary data stored within the main memory 130 through the NOR interface and NAND interface under the control of the host controller 310 and performs compression/decompression of the binary data. The memory controller 110 is provided with a compressor 460 for compressing the binary data to be stored within the main memory 130 and a decompressor 470 for decompressing the compressed binary data read out from the main memory 130. The memory controller 110 also is provided with a buffer for buffering the compressed binary data read out from the main memory 130 in unit of page such that the memory controller 100 can write the binary data within the mapping region through the NAND interface. The memory controller 110 controls the compressed data to be read through the NAND interface or the NOR interface according to the characteristics of the mapping areas of the main memory 130.

The secondary memories 123 and 125 can be implemented with two separate memories or can be implemented with a single memory having two separated regions. In this embodiment, it is assumed that the first and second secondary memories 123 and 125 are integrated into a package of the fusion memory device 100. The second secondary memory 125 buffers the binary data downloaded in a writing mode and the compressed data read out from the main memory 130 in the reading mode. The first secondary memory 123 buffers, in the writing mode, the compressed data to be written into the main memory 130 through the NAND interface, and buffers, in the reading mode, the decompressed code to be read from the pseudo NOR mapping area through the NOR interface. The secondary memories 123 and 125 can be implemented with a RAM. The main memory 130 includes a system data region for storing the codes and a user data region 137 for storing the user data. The system data region includes a pseudo NOR mapping area 133 in which the codes are accessed through the NOR interface and a RAM mapping area 135 in which the codes are accessed through the NAND interface. In a binary data writing mode, the memory controller 110 writes the data within the main memory 130 in unit of page. To buffer the data, the memory controller 110 may uses a buffer having a page size or use the secondary memories 123 and 125. In this embodiment, it is assumed that the secondary memories 123 and 125 are used for buffering the data. Here, the binary data to be written are buffered within the first secondary memory 123.

The fusion memory device 100 has been described with an implementation with the compressor 460 and decompressor 470 in this embodiment. However, the fusion memory device 100 can be implemented, without the compressor and decompressor, by dividing the main memory 130 into a system data region and user data region and dividing the system data region into a NOR interface access region and a NAND interface access region. Also, the fusion memory device 100 can be implemented with the compressor 460 and the decompressor 470 such that the main memory 130 can be accessed through only one of the NAND interface or the NOR interface. The operations of three types of fusion memory device 100 configured as above are described hereinafter.

The operation of a fusion memory device 100 implemented with a pair of compressor 460 and decompressor 470 and the main memory 130 having a NAND interface access region and a NOR interface access region is described hereinafter.

In the writing mode, when the host controller 310 downloads the code to be stored, the memory controller 110 of the fusion memory device 100 controls the second secondary memory 125 to buffer the downloaded code. Next, the memory controller 110 controls the compressor 460 to compress the code output from the second secondary memory 125 in a predetermined compression scheme and controls the first secondary memory 123 (or an internal buffer of the memory controller 110) to buffer the compressed code. Also, the memory controller 110 reads out the compressed code from the first secondary memory 123 in unit of page and writes the compressed code within the pseudo NOR mapping area 133 or the RAM mapping area 135 of the main memory 130 via the NAND interface. In accessing the code stored within the pseudo NOR mapping area 133, the memory controller 110 reads out the code from the pseudo NOR mapping area 133 via the NAND interface so as to be buffered within the second secondary memory 125. Next, the memory controller 110 controls the decompressor 470 to decompress the compressed code, realigns the decompressed code to be accessed via the NOR interface, and stores the realigned code within the first secondary memory 123. At this time, the host controller 310 accesses the code stored within the first secondary memory 123 via the NOR interface. The code accessed via the NOR interface is directly processed by the host controller 310. In the code stored within the RAM mapping area of the main memory 130, the memory controller 110 reads out the code from the RAM mapping area of the main memory 130 via the NAND interface, buffers the code within the second secondary memory 125, and controls the decompressor 470 to decompress the code such that the host controller 310 accesses the decompressed code via NAND interface and stores the code read out from the second secondary memory 125 within the host memory 320 corresponding to the RAM region 355 of the host memory map 330 as a real memory region. Consequently, the host controller 310 reads out the code from the host memory 320.

The operation of the fusion memory device 100 implemented with a main memory having a NAND interface access region and a NOR interface access region without a compressor and decompressor.

In this case, the fusion memory device 100 stores the downloaded binary data within a corresponding area of the main memory 130 via the NAND interface and reads out the binary data via the interface for the mapping area. In the case that the fusion memory device 100 operates in the writing mode, the host controller 310 downloads the code to be stored, and the memory controller 110 of the fusion memory device 100 writes the downloaded code within the pseudo NOR mapping area or the RAM mapping area of the main memory 130. In operating in reading mode, the memory controller 110 reads out the code stored within the pseudo NOR mapping area via NAND interface and reassigns the address such that the code is stored within one of the secondary memories 123 and 125 to be accessed via the NOR interface. The host controller 310 reads out the code stored within the secondary memories 123 and 125 via the NOR interface and processes the code. The code accessed via the NOR interface is directly processed by the host controller 310. In accessing the code stored within the RAM mapping area of the main memory 130, the memory controller 110 reads out the code from the RAM mapping area of the main memory 130 via the NAND interface, and the host controller 310 stores the code within the host memory 320 via the NAND interface. Consequently, the host controller 310 reads out the code from the host memory 320 and processes the code.

The operation of the fusion memory device 100 implemented with a pair of compressor and decompressor and a main memory having distinguishable interface access areas.

In the writing mode, the host controller 310 downloads the code to be stored, and the memory controller 110 of the fusion memory device 100 controls the second secondary memory 125 to buffer the downloaded code and controls the compressor 460 to compress the code read out from the second secondary memory 125 such that the compressed code is buffered within the first secondary memory 123 (or an internal buffer provided in the memory controller). The memory controller 110 accesses the compressed code stored within the first secondary memory 123 in unit of page and writes the code within the main memory 130 via the NAND interface. In reading out the code from the main memory 130, the memory controller 110 buffers the code read from the main memory 130 within the second secondary memory 125 and controls the decompressor 470 to decompress the compressed to recover the code. Consequently, the host controller 310 reads out the code from the fusion memory 100.

The operation of a fusion memory implemented with a pair of compressor and decompressor and a main memory having a system data region and a user data region, the system data region including a pseudo NOR mapping area and a RAM mapping area, is described hereinafter in more detail.

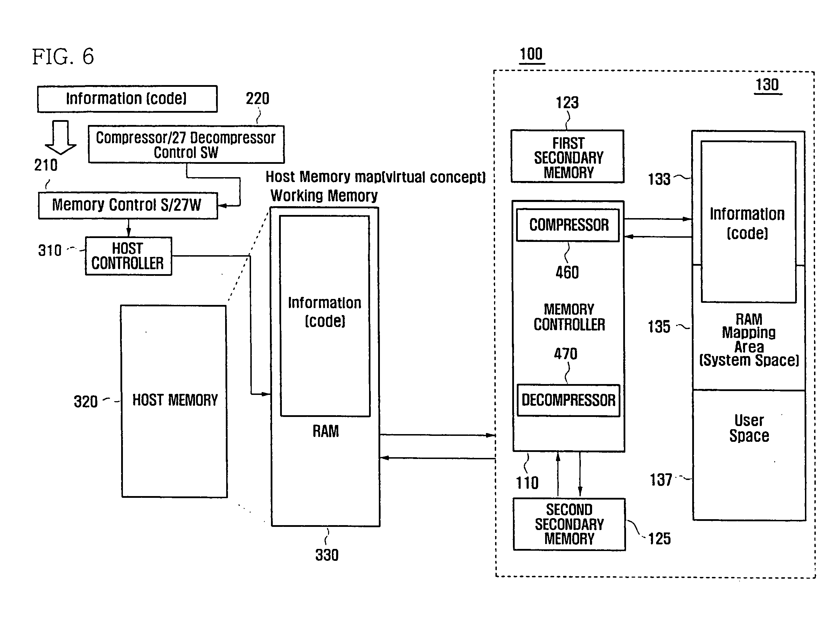

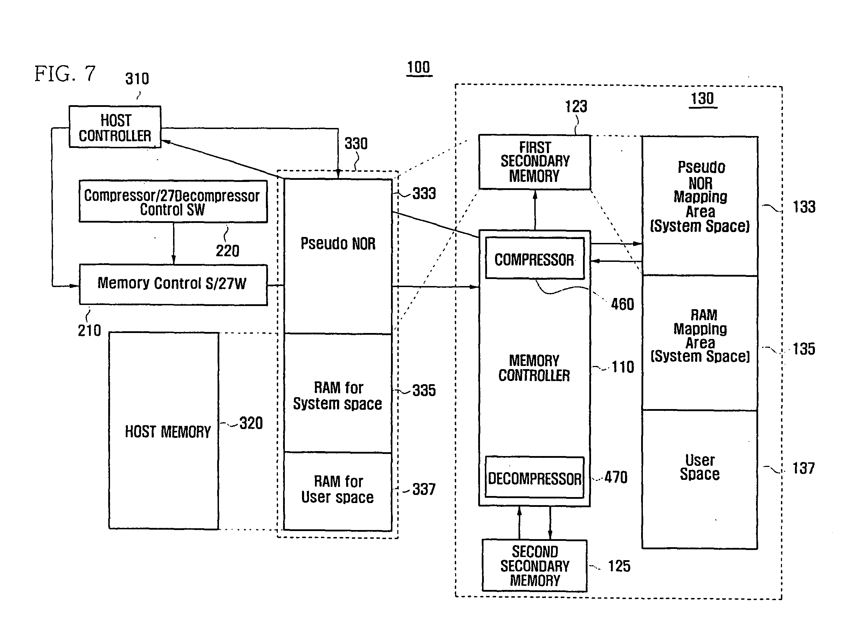

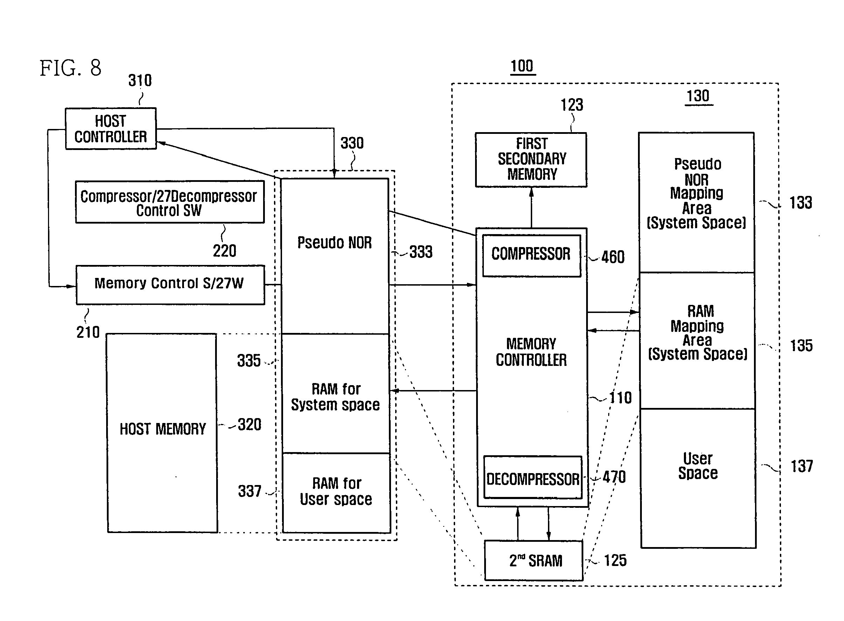

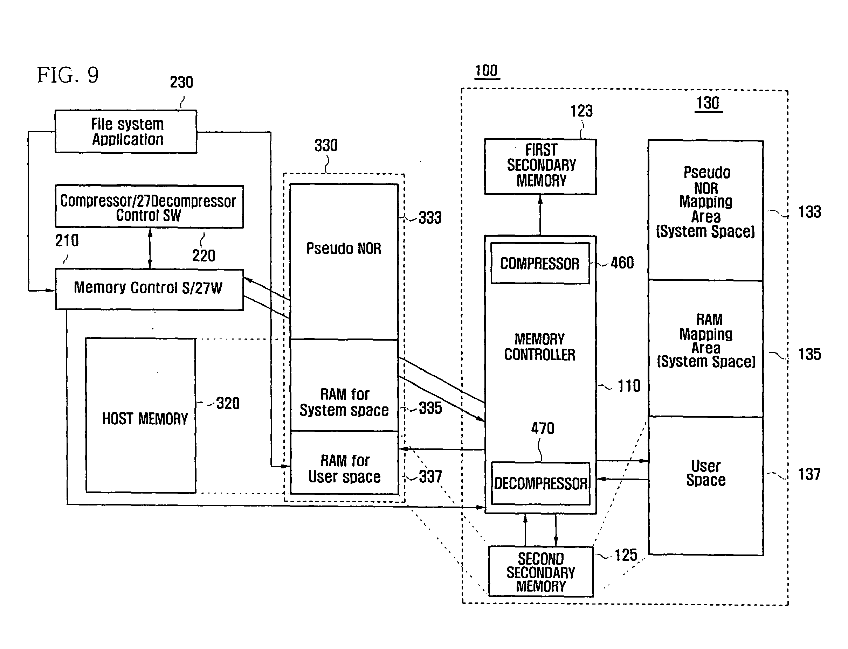

FIGS. 6, 7, 8, and 9 are block diagrams illustrating operations of a fusion memory device according to an exemplary embodiment of the present invention. FIG. 6 is a block diagram illustrating how to store a code within a fusion memory device according to an exemplary embodiment of the present invention, FIG. 7 is a block diagram illustrating how to read a code stored within a pseudo NOR mapping area of a fusion memory device according to an exemplary embodiment of the present invention, FIG. 8 is a block diagram illustrating how to read a code stored within a RAM mapping area of a fusion memory device according to an exemplary embodiment of the present invention, and FIG. 9 is a block diagram illustrating how to read/write a code within a user data region of a fusion memory device according to an exemplary embodiment of the present invention.

In FIG. 6, the fusion memory device 100 stores a downloaded binary data under the control of the host controller 310. Here, the binary data is a code is a program representing firmware and software.

In downloading a code within the fusion memory device 100, the memory control software 210 checks a size and address of the code for determining where to store the code in the main memory 130 and sets a flag for a compression scheme of the compressor/decompressor control software 220. Next, the host controller 310 temporarily stores the code within the host memory 320. Here, the code can be stored within the pseudo NOR mapping area 133 and/or the RAM mapping area 135. The code can be entirely stored within the pseudo NOR mapping area 133 or the RAM mapping area 135 or partially stored within the pseudo NOR mapping area 133 and RAM mapping area 135.

A host memory map 330 matches the pseudo NOR region 333, as a virtual region, and the RAM region of the host memory 320. The host controller 310 transfers the code stored within the host memory 320 to the fusion memory device 100 through a bus in cooperation with the memory control software 210. At this time, the memory control software 210 generates control information on a compression scheme and instructing the memory controller 110 of the fusion memory device 100 to store the compressed code within the pseudo NOR mapping area 133 and/or the RAM mapping area 135.

Upon receiving the control information, the memory controller 110 of the fusion memory device 100 operates such that the downloaded code is buffered within the second secondary memory 125 and the compressor 460 to compress the code read out from the second secondary memory 125 in the compression scheme and write the compressed code within the first secondary memory 123 (or an internal buffer of the memory controller 110). The memory controller 110 writes the compressed code read out from the first secondary memory 123 within a location of the main memory 130 via the NAND interface. Also, the compressed code can be stored within the main memory 130 without a buffering process. The storage location of the compressed code can be any of the pseudo NOR mapping area 133 or the RAM mapping area 135. After the compressed code is normally stored within the system data region of the main memory 130, the memory controller 110 reports the storage result to the host controller 310 such that the host controller 310 performs a next process.

The host controller 310 transfers the code stored within the host memory 320 to the fusion memory device 100 in such manner. The memory controller 110 compresses the binary data of the transferred code in a predetermined compression scheme, stores the compressed code within a predetermined mapping area of the main memory 130, and reports the storage result to the host controller 310. This procedure is repeated until the target codes are completely transferred. Since the code is stored within the system data region of the main memory 130 in the compressed format, the fusion memory device 100 can improve the storage efficiency.

When the code is stored within the main memory 130 of the fusion memory device 100, the compression scheme and storage address of the code are determined under the control of the host controller 310. The fusion memory device 100 buffers and compresses the code transferred from the host device and stores the compressed code within a mapping area of the main memory 130 via the NAND interface. The mapping area can be the pseudo NOR mapping area 133 or the RAM mapping area 135. In this embodiment, it is assumed that the code is compressed in an identical compression scheme regardless of the mapping areas and stored within the pseudo NOR mapping area 133 and/or the RAM mapping area 135 via the NAND interface.

In one embodiment, the code stored within the pseudo NOR mapping area 133 of the main memory 130 is accessed via the NOR interface to be read out, and the code stored within the RAM mapping area 135 is accessed via the NAND interface to be read out. The pseudo NOR mapping area 133 and RAM mapping area 135 access operations are sequentially described hereinafter.

FIG. 7 is a block diagram illustrating how to read out the code from a pseudo NOR mapping area of a fusion memory device according to an exemplary embodiment of the present invention.

When an access event occurs for executing a code stored within the system data region of the main memory 130, the control controller 310 checks whether the code is stored within the pseudo NOR mapping area 133 or the RAM mapping area 135. When it is determined that the code is stored within the pseudo NOR mapping area 133, the host controller 310 executes the memory control software 210 such that the memory control software 210 operates to read out the code from the pseudo NOR mapping area 133. The memory control software 210 receives a flag indicating the compression scheme assigned for the code stored at a corresponding address and transfers the control information on the address, command, and compression scheme to the memory controller 110 of the fusion memory device 100. When the control information is received, the memory controller 110 analyzes the control information and sets the code access scheme and decompression scheme of the decompressor 470 on the basis of the analysis result. Next, the memory controller 110 reads the code stored at the corresponding address of the pseudo NOR mapping area 133 of the main memory 130 via the NAND interface and stores the code within the second secondary memory 125. The decompressor 470 performs decompression on the compressed code read out from the second secondary memory 125. Consequently, the memory controller 110 converts the address of the code so as to be read out via the NOR interface such that the code is buffered within the first secondary memory 123. Here, the host controller 310 accesses the code stored within the first secondary memory 123 and processes the code in unit of byte.

As described above, the memory controller 110 of the fusion memory device 110 reads out the code from an address, via the NAND interface, indicated by a read command generated by the host controller 310 and stores the code within the second secondary memory 125. The code is recovered and then buffered within the first secondary memory 123 such that the host controller 310 to access via the NOR interface in unit of byte. The host controller 310 accesses the first secondary memory 123 and processes the code read out via the NOR interface. Here, the code is read out from the first secondary memory 123 and processed by the host controller 310.

In reading the code from the pseudo NOR mapping area 133, the memory controller 110 of the fusion memory device 100 reads out the code from the pseudo NOR mapping area 133 via the NAND interface and stores the code within the second secondary memory 125 such that the code is decompressed by the decompressor 470 and then buffered within the second secondary memory 125. Next, the memory controller 110 converts the address of the code within the second secondary memory 125 and stores the code within the first secondary memory 123 such that the host controller 310 accesses the code via the NOR interface. The address conversion and storage result are reported to the host controller 310 such that the host controller 310 reads out the code from the first secondary memory 123 via the NOR interface and processes the code. The code stored within the pseudo NOR mapping area 133 can be a program. In this case, the host controller 310 reads out the code from the secondary memory 120 of the fusion memory device 100 without buffering within the host memory 320. Accordingly, the fusion memory 100 can access the code via the NOR interface with the host device while accessing its main memory 130 via the NAND interface. By configuring to operate as above, the fusion memory device 100 has the advantages of the large memory capability of the NAND flash memory and high speed data access of the NOR flash memory.

Referring to FIG. 8, a code reading operation within the RAM mapping area 135 of the fusion memory 100 is described hereinafter.

As described above, when the read access event is detected, the host controller 310 checks where the target data to be read is located, i.e., in the pseudo NOR mapping area 133 or the RAM mapping area 135. The host controller 310 executes the memory control software 220 such that the memory control software 220 checks the compression scheme flag and outputs control information including the address, commands, and compression scheme for the data to the memory controller 110 of the fusion memory 100. Upon receiving the control information, the memory controller 110 of the fusion memory device 100 analyzes the control information to determine whether the data are stored in a compressed format. When the data is stored in a compressed format, the memory controller 110 controls the decompressor 470 to decompress the compressed data according to the access interface of the main memory 130 and the decompression flag. The memory controller 110 reads out the code stored at the address of the RAM mapping area 135 of the main memory 130 via the NAND interface and stores the code within the second secondary memory 125. Next, the decompressor 470 performs decompression on the code read out from the second secondary memory 125. After the code is decompressed, the memory controller 110 reports a decompression result to the host controller 310 such that the host controller 310 reads out the code from the second secondary memory 125 via the NAND interface and stores the code within the host memory 320.

Repeating the above procedure, the host controller 310 reads out the code from the RAM mapping area 135 of the main memory 130 of the fusion memory device 100 and writes the code within the host memory 320. At this time, the fusion memory device 100 reads out the code from the RAM mapping area 135, stores the code read out from the RAM mapping area within the second secondary memory 125, decompresses the code read out from the second secondary memory 125, and assigns an address of the RAM region 335 of the host memory map 330. The host controller 310 reads out the code from the address of the RAM region 335 via the NAND interface and stores the code within the host memory 320.

As described above, the memory controller 110 of the fusion memory device 100 reads out the code from the RAM mapping region 135 via the NAND interface, stores the code within the second secondary memory 125, and controls the decompressor 470 to decompress the code read out from the second secondary memory 125. Next, the memory controller 110 reports the decompression result to the host controller 310 such that the host controller 310 reads out the code from the fusion memory device 100 via the NAND interface and stores the code within the host memory 320. In this manner, the fusion memory device 100 allows the host device to access fusion memory device 100 via NAND interface while it accesses the main memory 130 via the NAND interface, too.

Referring to FIG. 9, a user data writing operation within the user data region 137 of the main memory 130 of the fusion memory 100 is described hereinafter.

In the user data writing mode, the user data can be stored within the user data region 137 of the main memory 130 in a specific format. In this embodiment, the user data is stored in the form of a file system. When a data write request is input by a user, a file system application 230 stores the user data within the host memory 320 and informs the memory control software 210 of the storage result such that the memory control software 210 outputs a data write command to the fusion memory device 100. At this time, the memory control software 220 sets a compression flag on the basis of the information received from a compressor/decompressor control software 220 and transfers the user data to memory controller 110 of the fusion memory device 100 with the flag and file name assigned for the user data.

Upon receiving the user data, the memory controller 110 of the fusion memory device 100 sets the compressor 460 according to a compression scheme indicated by the compression flag and controls such that the user data to be buffered within the second secondary memory 125. The user data buffered within the second secondary memory 125 is read out to be compressed by the compressor 460 in the compression scheme and then buffered within the first secondary memory 123. Next, the compressed user data are read out from the first secondary memory 123 and written at a specific address of the user data region 137 of the main memory 130 with the file name notified by the memory control software 210 via the NAND interface under the control of the memory controller 110. In such manner, the user data is written within the user data region 137 of the main memory 130 in the form of a compressed file, and the storage result is notified to the memory control software 210 by the memory controller 110.

Repeating the above procedure, the user data of the host device 300 are transferred to the fusion memory device 100 via the NAND interface and written within the user data region of the main memory 130 of the fusion memory device 100.

In the user reading mode, the user data is written from the user data region 137 of the main memory 130 of the fusion memory device 100.

When a data read request is input by the user for reading out a specific user data, the file application 230 assigns a buffer region to the host memory 320 for storing the user data, and the memory control software 210 outputs a data read command to the fusion memory device 100. At this time, the compressor/decompressor control software 220 generates sets a compression flag and transfers the compression flag to the memory control software 210. The memory control software 210 transmits a set of commands to the memory controller 110 of the fusion memory device 100 for reading out the user data. When the commands are received, the memory controller 110 sets the decompressor 470 according to the compression flag and controls such that the requested user data are to be read out from the user data region 137 of the main memory 130 via the NAND interface and buffered within the second secondary memory 125. At this time, the decompressor 470 decompresses the compressed user data read out from the second secondary memory such that the host controller 310 stores the user data output from the decompressor 470 within the host memory 320.

The user data compression can be performed in a compression scheme different from that for the code compression. In this case, the compressor-decompressor pairs can be independently structured for processing the user data and code, separately. The compressor can be implemented with a code compression module and a data compression module, and the decompressor can be implemented with a code decompressor and a data decompressor.

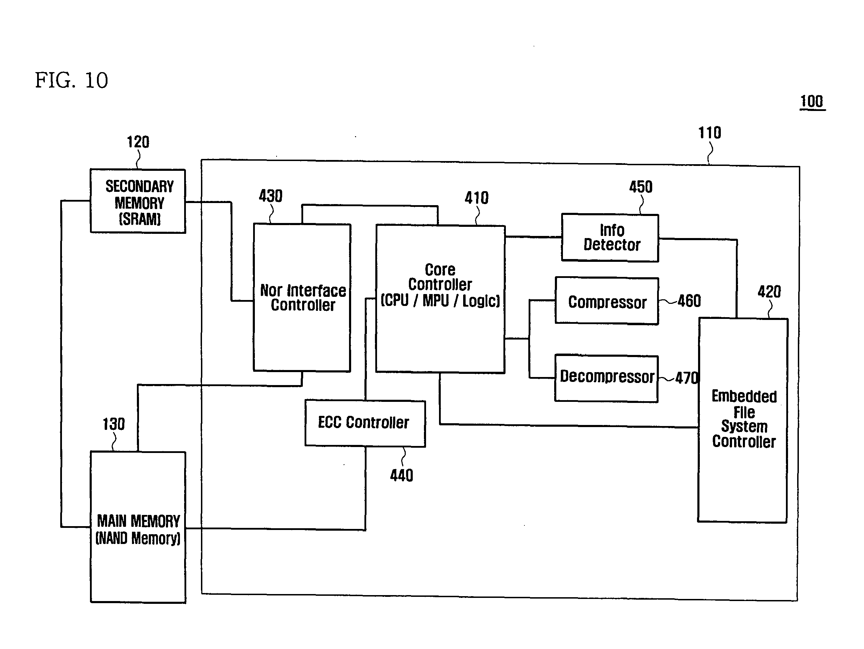

FIG. 10 is a block diagram illustrating a configuration of a fusion memory device according to an exemplary embodiment of the present invention.

Referring to FIG. 10, the fusion memory device 100 includes a memory controller 110, a secondary memory 120, and a main memory 130. The main memory 130 is provided with a system data region for storing the codes and a user data region for storing the user data. The system data region includes a pseudo NOR mapping area allowed to be accessed through a NOR interface and a RAM mapping area allowed to be accessed through a NAND interface.

The memory controller 110 includes a core controller 410 for controlling general operations of the memory controller 110, an embedded file system controller 420 for managing the user data within the user data region of the main memory 130, a NOR interface controller 430 for controlling the NOR interface access to the NOR mapping region of the main memory 130, an Error Correction Code (ECC) controller 440 for performing the ECC, an information detector 450 for detecting information on the compression flag and address in association with the binary data access, a compressor for compressing the binary data to be stored within the main memory 130, and a decompressor 470 for decompression the compressed data read out from the main memory 130.

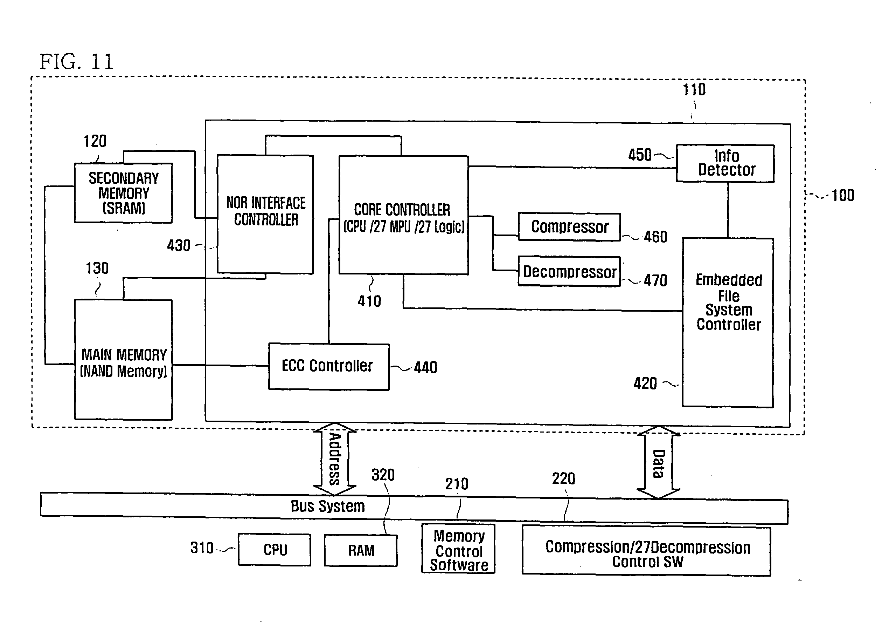

FIG. 11 is a block diagram illustrating an interoperation between the fusion memory device 100 of FIG. 10 and a host device according to an exemplary embodiment of the present invention.

Referring to FIG. 11, the host device includes a host controller (CPU) 310 and a host memory (RAM) 320. The host memory 320 is a memory for storing the binary data (including the code and user data) of the host device and acts as roll of the working memory of the host device. Also, the host device is provided with a host software module including a memory control software 210 for controlling the operation of the fusion memory device 100 and a compression/decompression control software 220 for controlling the compression/decompression on the binary data. The host software module is implemented within the host controller 310 such that the host controller 310 accesses the fusion memory device 100.

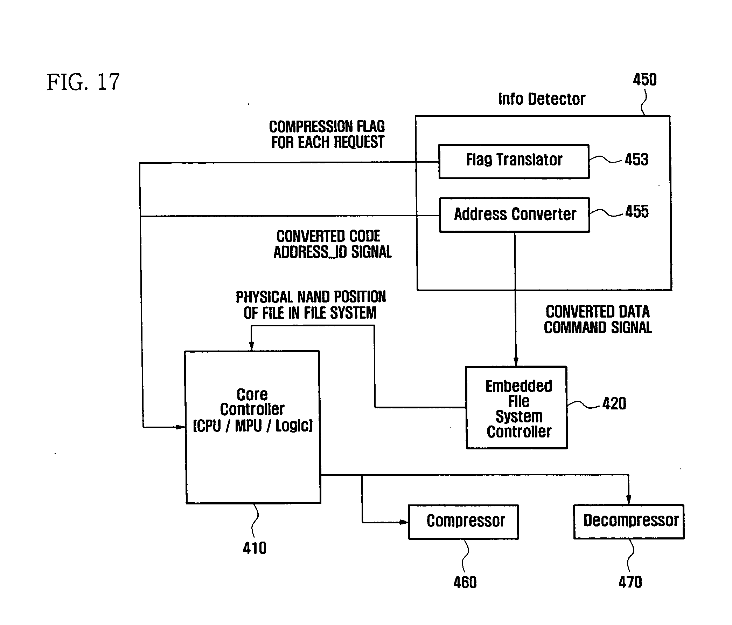

FIG. 17 is a diagram illustrating an operation of the information detector 450 of FIGS. 10 and 11.

Referring to FIG. 17, the information detector 450 is responsible for address conversion and compression scheme determination on the basis of the access control information generated by the memory control software 210 for accessing the binary data stored within the main memory 130. The information detector 450 is provided with a flag translator 453 which determines the compression scheme on the basis of the compression flag and an address converter 455 for converting the address at this the binary data to be stored. The flag translator 453 translates the compression flag of the control information on the binary data into a compression flag corresponding to the request and transfers the new compression flag to the core controller 410. The compression flag can be a CODE1.COMP indicating to compress the binary data to be stored within the pseudo NOR mapping area 133, CODE2.COMP indicating to compress the binary data to be stored within the RAM mapping region 135, and a DATA.COM indicating to compress the binary data to be stored with the user data region (file system area). The address converter 455 converts the address received from the host controller 310 into an address in the corresponding area of the main memory 130. In a code access mode, the address converter 455 outputs a code address_id signal to the core controller 410. The code address_id can acts as an identifier for indicating the pseudo NOR mapping area 133 or the RAM mapping area 135. In a user data access mode, the address converter 455 converts the address into a new address of the converted data command and transfers the new address to the file system controller 420. The file system controller 420 transfers the information of the actual position of the file to the core controller 410.

The core controller 410 determines the compression/decompression scheme of the binary data accessed on the basis of the output of the information detector 450 and the position of the binary data to be accessed in the main memory 130 on the basis of the output of the file system controller 420. Next, the core controller 410 controls such that the binary data is compressed according to the compression scheme and the compressed binary data is written within one of the pseudo NOR mapping area 133, RAM mapping area 135, and user data area of the main memory 130 according to the converted address information. The core controller 410 can be implemented with a page buffer for writing the compressed data within the main memory 130 via the NAND interface. In this case, the core controller 410 controls such that the data compressed by the compressor 460 is buffered within the page buffer and the data read out from the page buffer is written in a corresponding area of the main memory 130 via the NAND interface. In this embodiment, it is assumed that the page buffering is performed with the first secondary memory 123. In the binary reading mode, the core controller 410 accesses the compressed binary data stored within an area (pseudo NOR mapping area, RAM mapping area, or file system area) of the main memory 130 and controls the decompressor 470 to decompress the compressed binary data read out from the corresponding area according to the compression scheme.

Codes reading and writing procedures of the above structured fusion memory device are described hereinafter.

The core controller 410 analyzes the output of the information detector 450 and determines whether a binary data read command or binary data write command is input. When a binary data write command is input, the core controller 410 checks a target storage area (pseudo NOR mapping area, RAM mapping area, and file system area) and compression scheme on the basis of the compression flag and converted address output from the information detector 450. Next, the core controller 410 controls the secondary memory 120 to buffer the binary data and controls the compressor 460 compresses the binary data read out from the secondary memory 120. Sequentially, the core controller 410 controls such that the compressed binary data is stored within an area corresponding to the converted address. At this time, the binary data (code or user data) are stored within the corresponding area of the main memory 130 via the NAND interface. Concerning to the pseudo NOR mapping area 133 and the RAM mapping area 135 of the main memory 130, the code is stored via the NAND interface.

When a binary data read command is input, the core controller 410 analyzes the flag and address detected by the information detector 450 and checks the area of the main memory 130 for reading out the binary data and decompression scheme. When the binary data is stored within the pseudo NOR mapping area 133, the core controller 410 reads out the binary data from the pseudo NOR mapping area 133 of the main memory 130 via the NAND interface and stores the binary data within the secondary memory 120 such that the decompressor 470 decompresses the compressed binary data read out from the secondary memory 120. Next, the core controller 410 controls the NOR interface controller 430 to buffer the decompressed binary data within the secondary memory 120 such that the host controller 310 reads the buffered binary data via the NOR interface. The NOR interface controller 430 converts the address of the decompressed binary data and stores the secondary memory 120 such that the host controller 310 to access in unit of byte. When the binary data is stored within the RAM mapping area 135, the core controller 410 reads out the binary data from the RAM mapping region of the main memory 130 and stores the binary data within the secondary memory 120 such that the decompressor 470 decompresses the binary data read out from the secondary memory 120. The host controller 310 reads the binary data via the NAND interface and stores the binary data within the host memory 320.

User data reading and writing procedures of the above-structured fusion memory device are described hereinafter.

When a user data write command is input, the information detector 450 detects a target address of the main memory 130 and compression information for storing the user data and transfers the address and compression information to the file system controller 420. The file system controller 420 checks the type of the user data (file system) and outputs the compression information and storage location information to the core controller 410. The core controller 410 sets the compressor 460 with a compression scheme determined on the basis of the compression information and buffers the user data downloaded for the host device within the secondary memory 120. At this time, the compressor 460 compresses the user data read out from the secondary memory 120 according to the compression scheme and the core controller 410 writes the compressed user data within the user data region of the main memory 130 via the NAND interface.

When a user data read command is input, the information detector 450 detects information on the storage location of the main memory 130 and decompression scheme outputs the address and decompression information to the file system controller 420. The file system controller 420 forwards the address and decompression information to the core controller 410. The core controller 410 determines the decompression scheme according to the decompression information, reads out the user data from the address of the user data region of the main memory 130, and stores the user data within the secondary memory 120. The decompressor 470 decompresses the compressed user data and notifies the host device of the decompression completion such that the host device reads out the buffered user data and stores the user data within the host memory 310.

In the above descriptions, the data reading and writing procedures of the fusion memory device implemented with different types of compressors and decompressor are explained. However, the fusion memory device can be implemented with a pair of compressor and decompressor for a specific data type.

The structures and operation of the compressor 460 and decompressor 470 are described hereinafter in more detail.

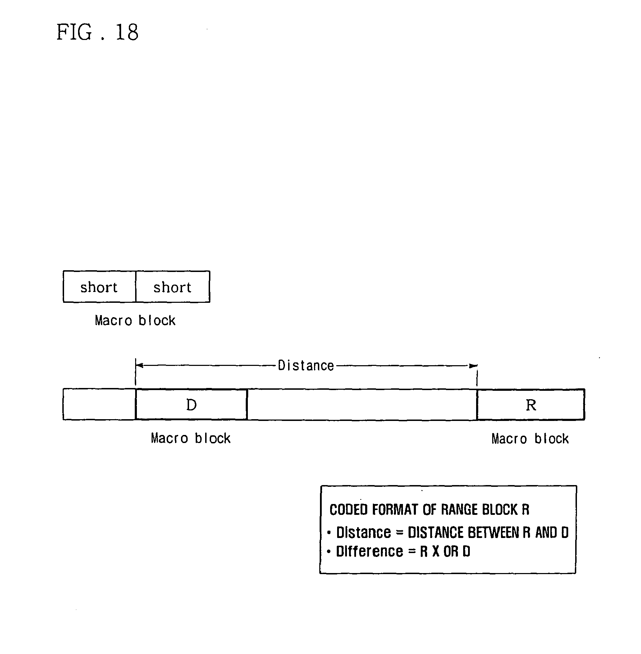

The compressor 460 and decompressor 470 can operate in a normal compression/decompression method. The structures and operation of the compressor 460 and decompressor 470 of the present invention are described with reference to FIGS. 18 to 23.

FIG. 18 is a schematic view illustrating a data format used in a fusion memory device according to an exemplary embodiment of the present invention.

In FIG. 18, the term "macroblock" denotes a unit of data for compression, and the term "short block" is a unit of data constituting the macroblock. A macroblock consists of at least one short block. The macroblock can be composed of the short blocks or not. In this embodiment, it is assumed that a macroblock consists of two short blocks. The term "range block" means a macroblock to be compressed. The term "domain block" means a macroblock referred for compressing the range block. The domain block may be the macroblocks in a search range. The term "distance" means a distance between the range block and the domain block. The term "difference" means a difference between the range block and the domain block. The difference is obtained by exclusive OR (XOR) operation of the range block and the domain block.

In the following description, an exception handling is acceptable when there is no domain block of which data is not identical with that of the range block. In this case, the raw data is used without compression. A global table is a fixed entry table in which the difference value is used as an index. A local table is a floating entry table in which the difference value between the frequent range block and domain block is used as an index. A searching range is for searching for a domain block in the range block. A forward search is of testing the macroblocks positioned prior to the range block in the searching range. A backward search is of testing the macroblocks to the range block. The term "binary data" is used for the program data and user data.

Preferably, the compressor and decompressor for processing the binary data have high compression and decompression rates. The higher the compression rate of the compressor is, the lower the compression/decompression speed of the compressor/decompressor. In this embodiment, how to improve the compression rate and decompression speed is described in association with the domain block search procedure.

The compressor 460 according to an embodiment of the present invention uses an entropy coding on the difference value of the range block and domain block and a cost table-based coding in which a cost table is selectively used according to a cost obtained from the difference value.

The former compression method searches for the domain blocks in the searching range in the forward and backward directions and performs the entropy coding on the difference with an identical or most similar domain block. In a case that the range block differs from all the domain blocks in the searching range, the exception handling may be used.

The latter compression method has the characteristics as following.

First, the compressor 460 performs the search in the forward and backward directions as comparing the range block with the domain blocks (i.e., the macro blocks positioned before the range block) in the searching range in the forward and backward directions and selects a domain block having the lowest cost.

Second, in compressing the range block similar to the domain block, the compression rate and speed can be improved by using the table. For this purpose, the compressor 460 calculates the cost while comparing the binary data of the range block with those of the domain blocks in the searching range. There can be a fixed global table and a floating local table. The cost table is matched to the index of the global table or the local table according to the cost value. The global table is a table stored the frequently used data and the data are not changed. The local table is a table which is formed with the data frequently used during the compression process and it is stored following the binary data after the data compression has completed.

Finally, the compressor 460 compresses the binary data in unit of macroblock, and performs an exception handling when there is no domain block identical with or similar to the range block in the searching range (i.e., in a case that there is no short block identical with the short block of the range block). The exception handling is performed without compression the binary data of the range block for adjusting the decompression rate and speed.

The binary data compression method according to an embodiment of the present invention searches for the binary data of the macro block in the forward and backward direction without reduction of the compression speed, whereby improving the compression rate. Also, by efficiently storing the compression information is within the global table and local table, the compression rate can be improved. Furthermore, the macroblock whose compression rate is bad is processed with the exception handling method, whereby the compression rate and decompression speed can be adjusted.

The entropy compression method and the table-based compression method are described hereinafter in sequential order.

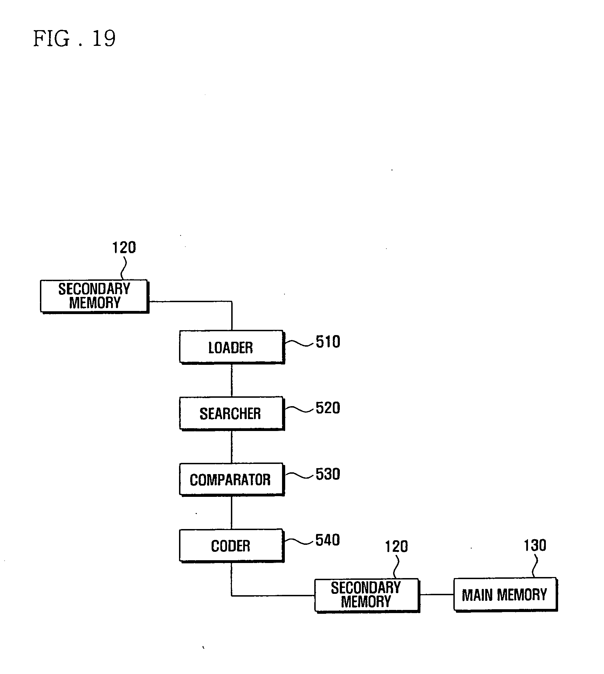

FIG. 19 is a block diagram illustrating a compressor of a fusion memory device for compressing binary data according to an exemplary embodiment of the present invention.

In FIG. 19, the compressor 460 includes a loader 510, a searcher 520, a comparator 530, and a coder 540.

Referring to FIG. 19, the loader 510 loads the binary data read out from the secondary memory 120 in unit of compression data size. The binary data buffered within the secondary memory 120 are raw binary data downloaded from the host device. The compressing data size means a binary data size to be compressed at a time (i.e., the compression frame size). After the binary data is loaded, the searcher 520 loads the searching range and range block and starts searching for the domain block of which binary data is identical with or similar to that of the range block. At this time, the searcher performs searching operation in the forward and backward directions. The comparator 530 compares the domain blocks searched by the searcher 520 with the range block and outputs difference values of the binary data of the range block and domain blocks. The comparator 530 can be implemented with an XOR operator.

The coder 540 analyzes the outputs of the comparator 530, outputs values of the distance and difference between the range block and domain blocks, and selects the lowest values of the distance and difference as the compressed data information. As described above, the range block may consist of more than two short blocks. The coder 540 compares the binary data of the range block with those of the domain blocks in the searching range and selects at least one of the short blocks of which binary data is identical with that of the range block. Next, the coder 540 stores the distance and difference between the range block and the selected domain block as the compressed data of the range block.

However, there can be uncompressed range block data. For example, in the case that the short block data constituting the range block are not identical with the short block binary data of the domain blocks in the searching range, the range block is processed as the exceptional data block. When the compression cost of the range block is greater than a threshold value, the binary data of the range block is stored without compression. In this case, the coder 540 stores the binary data of the range block within the secondary memory 120 as it is.

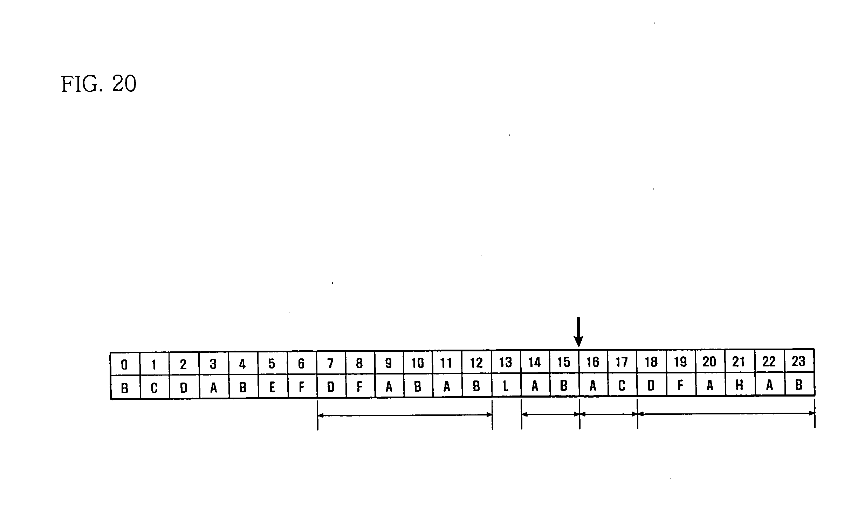

FIG. 20 is a diagram illustrating how a distance and difference between a range block and domain blocks in a searching range are compared by the code 540 of FIG. 19. In FIG. 20, it is assumed that there are 4 range blocks of [16:17], [18:19], [20:21], and [22:23].

The coder 540 may use a distance flag and a difference flag according to whether the distance and differences values vary. In a case that the current range block has a distance value identical with that of the previous range block, a distance flag indicating that there is no distance change is used. In the meantime, when the current range block has a distance value different from that of the previous range block, a distance flag indicating that there is a distance change and distance value are used.

When there is a domain block of which data is identical with that of the range block, a difference flag indicating that there is no difference between the range block and domain block. When there is a domain block of which data is not identical with but similar to that of the current range block, a difference flag indicating that there the data are different and a difference value indicating how much different from each other. In this embodiment, the distance and difference flags are set to "0" for indicating no distance change and no difference, and set to "1" for indicating the distance change and difference between the blocks. The distance flag and value are called as the distance information and the difference flag and value are called as the difference information, hereinafter.

Referring to FIG. 20, a domain block mostly similar to the range block [16:17] having the data A and C in the searching range is [14:15] having the data A and B. In this case, the distance between the range block [16:17] and the domain block [14:15] is expressed as "1,2", and the difference is expressed as "0,1, C XOR B." The 1 of the distance information "1,2" is the distance flag indicating that the two blocks have different data, and the 2 of the distance information "1,2" is the distance value indicating that the domain block is positioned prior to as many as 2 block.

The 0 of the difference information "0,1, C XOR B" is the difference flag indicating that first short blocks of the range block and domain block are identical with each other, the 1 is the difference flag indicating that second short blocks of the range block and domain blocks are different from each other, and C XOR B is a difference value.

Also, a domain block identical with or mostly similar to the range block [18:19] having the data D and F in the searching range is the domain block [7:8] having the data D and F. In this case, the distance between the range block [18:19] and the domain block [7:8] is "1,11" and the difference is "0,0."

As another example, a domain block similar to and close to the range block [20:21] having the data A and H in the searching range is the domain block [9:10] having the data A and B. In this case, the distance is "0", since the previous range block [18:19] having the same data D and F, and the difference is "0,1,H XOR B."

As another example, a domain block identical with or mostly similar to the range block [22:23] having the data A and B in the searching range is the domain block [11,12] having the data A and B. In this case, the distance between the blocks is "0" and the distance is "0,0."

Accordingly, the compression on the macroblocks [16 - 23] can be informed as Table 1. Table 1 shows compressed data information for the compressor which does not use the table. In a case that the compressor 460 performs compression using the table, the compressor 460 can use the compressed data information stored with the difference values "C XOR B" and "H XOR B" as the indexes within the global table. In a case that the global table has difference value index of "C XOR B" and "H XOR B", the compressor 460 can use the compression data stored with the difference value as the indexes within the floating table.

**Table 1**

| | |
|---|---|
| Distance | 1,2,1,11,0,0 |
| Difference | 0,1, C XOR B, 0,0, 0,1, H XOR B, 0,0 |

The data compressed as above are buffered within the secondary memory 120, and the buffered compressed data are stored within a specific area (pseudo NOR mapping area, RAM mapping area, and user mapping area) of the main memory under the control of the core controller 410. The compressed data can be read out from the main memory 130 and buffered within the secondary memory 120 such that the decompressor 470 decompresses the compressed data read out from the secondary memory 120.

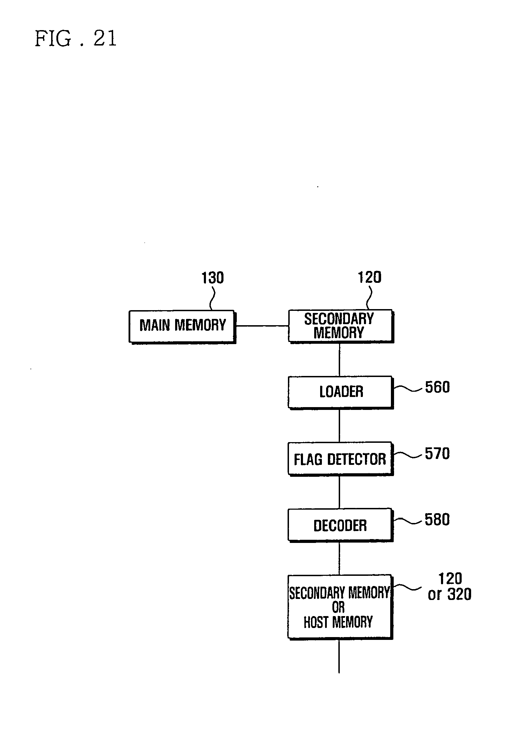

FIG. 21 is a block diagram illustrating a decompressor of a fusion memory device for decompressing the compressed binary data according to an exemplary embodiment of the present invention.

In FIG. 21, the decompressor includes a loader 560, a flag detector 570, and a decoder 580.

Referring to FIG 21, the loader 560 loads the compressed data on the secondary memory 120. As described above, the compressed data information includes the distance and difference from the main block. The distance information consists of a distance flag and a distance value, and the difference information consists of a difference flag and a difference value. The flag detector 570 detects the distance flag and value and the difference flag and value from the distance information and difference information and transfers the flags and values to the decoder 580. When the flags and values are received, the decoder 580 analyzes the flags and values, determines the position of the domain block relative to the range block on the basis of the flags and values, and decompresses the data of the range block in comparison with the domain block determined by the distance flag and value. In a case where an exception flag is detected by the flag detector, the decoder 580 processes the data of the range block according to the exception handling method. In this case, the decompressor 470 outputs the range block as it is. The data decompressed as above is buffered within the secondary memory 120 and read out from the second memory 120 to be stored within the host memory 320 or directly processed, when the data is a code of the pseudo NOR mapping area 133, by the host controller 310.

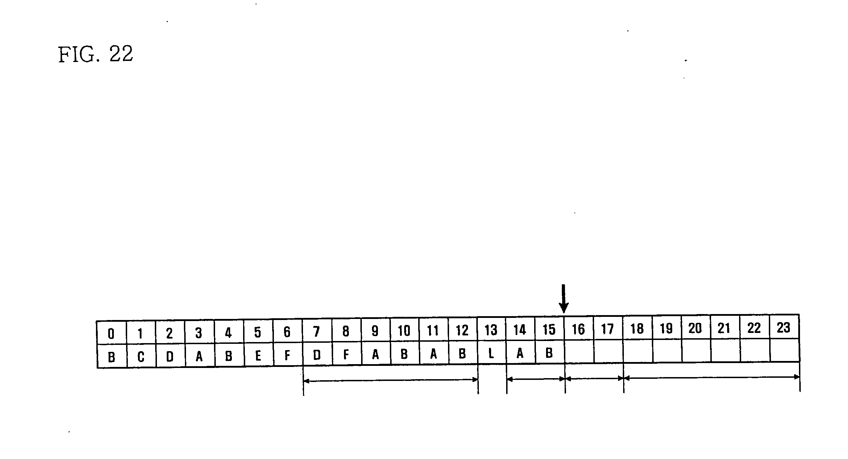

FIG. 22 is a diagram illustrating how the compressed data is decompressed by the decompressor 470 of the fusion memory device 100 according to an exemplary embodiment of the present invention. In this embodiment, the decompression procedure is described with the example of the compressed data information of table 1. Table 1 shows the compressed data information of the range blocks [16,17], [18,19], [20,21], and [22,23], and the decompressor 470 generates the binary data as shown in FIG. 22 using the compressed data information of Table 1.

Referring to FIG. 22, the compressed data information on the range block [16,17] includes a distance flag set to 1, a distance value set to 2, a difference flag set to 0 for indicating that the first short block of the range block is identical with the first short block of the domain block, and difference value set to C XOR B indicating that the second short block of the range block differs from the second short block of the main block. Accordingly, the decompressor 470 recovers the 16^{th} short block with the 14^{th} short block having the data A and recovers the 17^{th} short block having the data C by performing a operation of B XOR(C XOR B) on the 15^{th} short block {distance:2, ref 16-2=14, diff=0, inst(16)=inst(14)=A, inst(17)=B XOR (C XOR B)= C}. Also, the compression data information on the range block [18,19] includes a distance flag set to 1, a distance value set to 11, a difference flag and value are set to 0 indicating that the first and second short blocks of the range block are identical with those of the domain block. Accordingly, the decompressor 470 recovers the 18^{th} short block with 7^{th} short block having the data D and recovers the 19^{th} short block with the 8^{th} short block having the data F {distance: 11, ref 18-11=7, diff=0, inst(18)=inst(7)=D, ref 19-11=8, diff=0, inst(19)=inst(8)=F}. In this manner, the original data (see FIG. 20) can be recovered from the compressed data with reference to the table 1.

FIGS. 19, 20, 21, and 22 have shown the binary data compression and decompression methods using the entropy coding scheme. However, the binary data compression and decompression method can be implemented with a table-based coding scheme rather than the entropy coding scheme. A table-based compression procedure of the compressor 460 of the fusion memory device is described hereinafter.

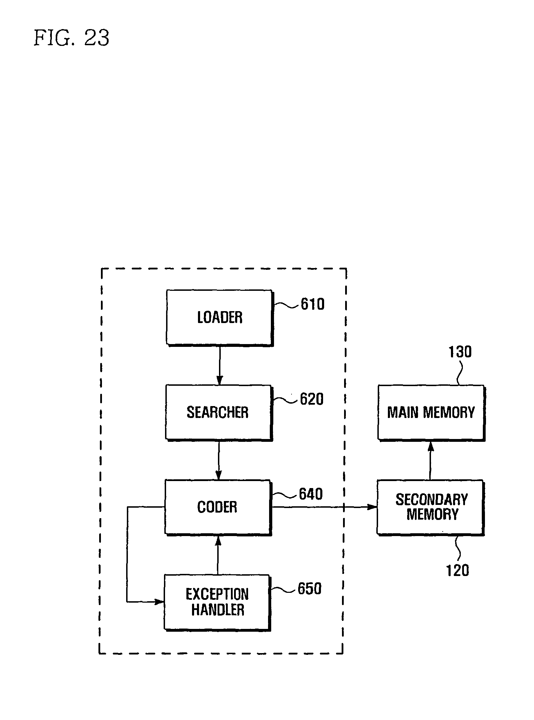

FIG. 23 is a block diagram illustrating a configuration of a compressor of a fusion memory device according to an exemplary embodiment of the present invention.

Referring to FIG. 23, the compressor 460 includes a loader 610, a searcher 620, a coder 640, and an exception handler 650.

The loader 610 loads the binary data downloaded from an external device. The binary data is loaded in unit of a specific data size (compression frame size) suitable for the coder 640. The coder 640 performs compression in unit of data size called compression data size. The loader 610 loads the binary data of which size is smaller than the size of the secondary memory 120 and the entire binary data loaded on the secondary memory can be a compression frame or segmented to be fit for the compression frame size.

The searcher 620 determines a searching range of the binary data of the compression frame and checks the range blocks. Next, the searcher 620 compares the range block with the domain blocks in the searching range to calculate the costs and determines the distance information and cost value of the domain block with of which cost is the lowest. The search operation is performed in the forward and backward direction while comparing the range block and the domain blocks in the searching range. After the difference value between the range block and each domain block is calculated, the searcher 620 generates information on the distance and difference between the range block and the domain block when the range block and the domain block are identical with each other. On the other hand, when the range block and the domain block differ from each other, the searcher 620 calculates a cost using the distance and difference information. The searcher 620 can be provided with a cost table. The cost table is structured such that the cost values calculated on the basis of the difference values between the range block and the domain blocks are mapped to the indexes of a global table or a floating table. The searcher 620 generates the difference values by comparing the data of the range block and the respective domain blocks in the forward searching process. Also, the searcher 620 stores the cost values generated during the backward direction and compares the cost values with the previously stored reference cost. When the current cost is lower than that of the reference cost, the reference cost is updated, and otherwise, maintains the reference cost. Repeating this process, a domain block with which the lowest cost is obtained is found. The searcher 620 outputs the distance information and cost between the range block and the domain block that generates the lowest cost to the coder 640. This operation is repeated until all the range blocks are processed.

The coder 640 may be provided with a global table (fixed table) and/or a local table (floating table). The global table and local table can be buffered within the secondary memory 120. The global table can be buffered within a specific region of the secondary memory 120 when the binary data to be compressed is downloaded. Also, the local table generated while compressing the binary data can be buffered within a specific region of the secondary memory 120. The global table is built with the costs calculated with the differences frequently appear while compressing the binary data and the costs calculated during the binary data compression are used as the compressed data information. The global table is a fixed table built with the experimentally measured values. The local table is built by calculating the costs on the basis of the differences frequently appear during the binary data compression and the costs calculated during the binary data compression are used as the compression data information. The local table is a variable table and used only for compression and decompression on the corresponding binary data. The global and local tables are similar to the cost table. The cost table uses the differences between the blocks as the indexes and stores the cost values at the index positions, and the global and local tables are indexed and the difference values between the blocks are stored at the index positions.

In the following description, it is assumed that both the global and local tables are used for compressing the binary data. However, the binary data compression can be performed with one of the global and local tables.

The coder 640 checks the data (comparison data of the range block and domain block) stored at a position of the index corresponding to the cost value and processes the index of the corresponding data as coding data. The cost can be calculated, at the searcher 620, on the basis of the difference information of the range block and domain block. In this embodiment, the searcher 620 calculates the cost using the cost table. The searcher 620 transfers the distance information (distance flag and distance value) and the cost value to the coder 640. The coder 640 checks the data with reference to the cost value and compresses the data as the binary data of the corresponding range block.

The operations of the searcher 620 and coder 640 are described hereinafter in more detail. In this embodiment, it is assumed that the range block consists of at least two short blocks. The searcher 620 calculates the difference between the range block and domain block and obtains the cost from the difference. When the difference between range block and domain block is 0, i.e. the range block and domain block are identical with each other, the cost value becomes 0 (or the lowest cost value). When at least one short block of the range block is identical with at least one short block of the domain block, the cost value is calculated using the difference values between the rest short blocks of the range block and domain block. The coder 640 compares the cost value to the coding threshold value and refers, when the cost value obtained between the range block and the domain block is less than the coding threshold value, to the global table and/or local table. The cost values can be used as the index of the global and local tables, and the coding value obtained from the short blocks different from each other can be the calculated cost value. When all the short blocks of the range block and the domain blocks give respective difference values, i.e. all the pairs of the corresponding short blocks of the range and domain blocks are different from each other, the cost value calculated by the searcher 620 becomes greater than the coding threshold value. In this case, the coder 640 processes the range block as an exceptional data block.

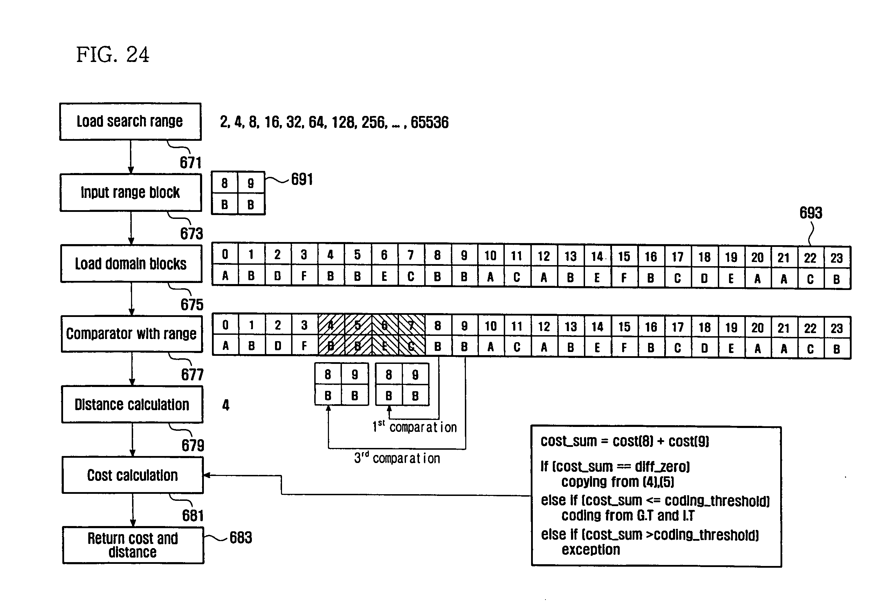

FIG. 24 is a flowchart diagram illustrating an operation of the searcher 620 of FIG. 23. In FIG. 24, it is assumed that a range block 691 consists of 8^{th} and 9^{th} short blocks. In this case, the domain block consists of two short blocks. For example, the pairs of the 6^{th} and 7^{th} short blocks, the 5^{th} and 6^{th} short blocks, the 4^{th} and 3^{rd} short blocks, the 3^{rd} and 2^{nd} short blocks, 2^{nd} and 1^{st} short blocks, and the 1^{st} and 0^{th} short blocks are regarded as the domain blocks. A compression target data 693 downloaded from the host controller 310 is buffered within the secondary memory 120.

Referring to FIG. 24, the searcher 620 loads a searching range at step 671. The searching range is represented by a number of macroblocks which can be 2, 4, 8, 16,..., 65536. After the searching range is determined, the searcher 620 loads the range block to be compressed at step 673. Here, the range block consists of the 8^{th} and 9^{th} short blocks. Next, the searcher 620 selects the domain blocks to be compared with the range block in the searching range at step 675. The domain block selection is performed in the forward direction and the short blocks of each domain block are targeted. After the domain block is selected, the searcher 620 compares the binary data of the domain block with the binary data of the range block at step 677. The comparison can be performed by the exclusive-OR (XOR) operation. Next, the searcher 620 calculates distance information between the range block and the domain block at step 679 and computes the cost value on the basis of the distance information at step 681. Here, the distance information can include the distance flag and the distance value. The cost value can be obtained from the distance value. The searcher 620 selects the cost value from the cost table according to the difference value between the range block and the domain block. At this time, the cost value can be matched with the experimentally obtained difference value. Preferably, the cost value is set such that the most frequently appeared difference value is matched with the lower cost value.

Performing the above procedure, the searcher 620 calculates the distance information and costs between the range block and the respective domain blocks in the searching range and stores the distance information and cost value obtained with the domain block giving the lower cost. The searcher 620 calculates the distance information and cost of the range block in association with the domain blocks while searching in the forward direction (i.e. range block is sequentially compared with the respective domain blocks in the forward direction), and updates the cost whenever a lower cost is detected while searching in the backward direction. When the currently calculated cost is less than the previously calculated cost, the searcher 620 stores the distance information and cost obtained with the current domain block, and otherwise, the searcher 620 maintains the distance information and cost obtained with the previous domain block. Repeating the above operations, the searcher 620 stores the distance information and cost of the range block in association with the domain block which gives the lowest cost in the searching range.

The searcher 620 may generate a local table. When a difference value (distance value of the range block and the main block) is appeared over a predetermined number of times (for example, 3 times) in spite of no registration to the global table, the difference value is registered to the local table. Preferably, the cost of the local table is set to a value greater than that of the global table. The difference value may be registered to the cost table. In this case, although the difference value is not registered to the global table, it is possible to improve the efficiency of the compression by registering the frequently appeared distance value to the cost table.

After completion of the searching process, the searcher 620 transfers the distance information and cost to the coder 640 at step 683.

In FIG. 24, the searcher 620 segments the buffered binary data 693 into the macroblocks and indexes and searches the 6^{th} and 7^{th} pair domain block, the 5^{th} and 6^{th} pair domain block, the 4^{th} and 5^{th} pair domain block, ...0^{th} and 1^{st} pair domain block, positioned prior to the current 8^{th} and 9^{th} pair range block, in a sequential order. The searcher 620 compares the binary data of the range block with the binary data of the selected domain block and outputs the comparison result. In this case, the searcher 620 generates the difference value by comparing the range block and the domain block, i.e. E XOR B and C XOR B for the domain block of the pair of 6^{th} and 7^{th} short blocks, B XOR B and E XOR B for the domain block of the pair of 5^{th} and 6^{th} short blocks, B XOR B and B XOR B for the domain block of the pair of 4^{th} and 5^{th} short blocks, F XOR B and B XOR B for the domain block of the pair of 3^{rd} and 4^{th} short blocks, D XOR B and F XOR B for the domain block of the pair of 2^{nd} and 3^{rd} short blocks, B XOR B and D XOR B for the domain block of the pair of 1^{st} and 2^{nd} short blocks, and A XOR B and B XOR B for the domain block of the pair of 0^{th} and 1^{st} short blocks. Also, the searcher 620 generates the distance information between the range blocks and the respective domain blocks.

Next, the searcher 620 calculates the cost on the basis of the distance values. In a case that the binary data of the short blocks constituting the domain block are identical with those of the range block are identical (4^{th} and 5^{th} short blocks in FIG. 24), the cost may be set to 0. In the case that one of the two short blocks of the domain block is identical with one of the short blocks of the range blocks (the 5^{th} and 6^{th} short blocks, 3^{rd} and 4^{th} short blocks, 1^{st} and 2^{nd} short blocks, and 0^{th} and 1^{st} short blocks), the cost can be lower than the coding threshold value. In the case that both the short blocks of the domain block differ from those of the range block, the cost can be greater than the coding threshold value. In FIG. 24, the searcher 620 transfers the distance information (distance flag=1 and distance value=4) and the cost=0 obtained in association with the 4^{th} and 5^{th} short blocks to the coder 640. In a case where no domain block whose cost is 0 (or close to 0) exists, the searcher 620 transfers the distance information and cost obtained in association with the domain block having the lowest cost to the coder 640 (for example, the 0^{th} and 1^{st} short blocks generates the distance information (distance flag=1, distance value=8, and cost≠0).

When the distance information and cost are received, the coder 640 performs compression on the binary data of the range block on the basis of the distance information and cost.

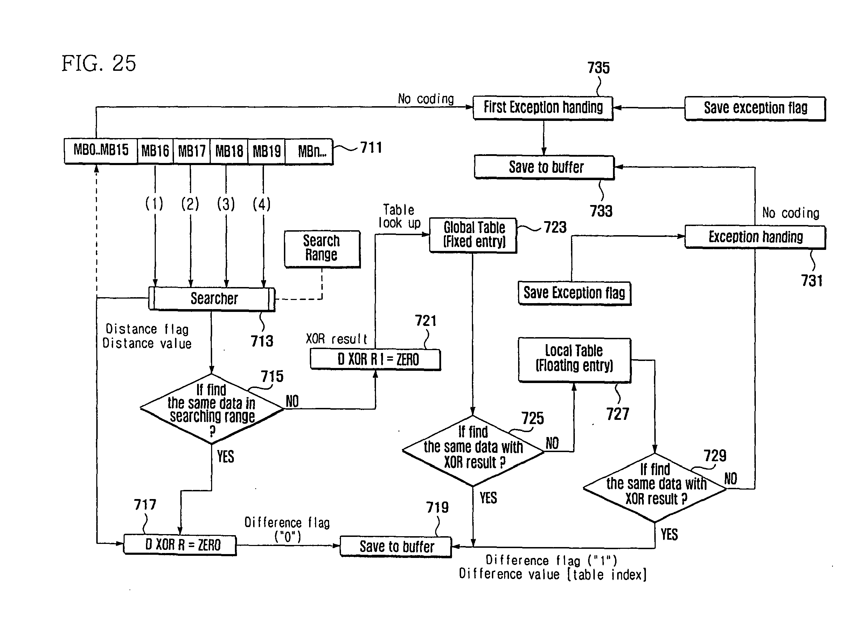

FIG. 25 is a flowchart illustrating a binary data compression operation of the coder 640 of FIG. 23.

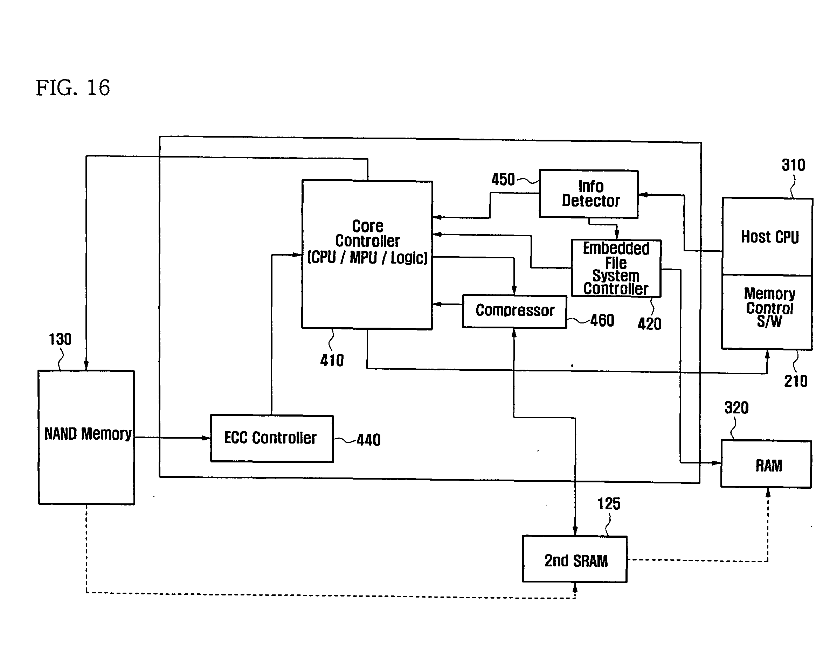

Referring to FIG. 25, when the binary data is downloaded from the host device, the core controller 410 buffers the downloaded data within the second secondary memory 125. The loader 610 loads the downloaded binary data (711). At this time, the loaded data is partitioned in unit of macroblock. At this time, the macroblocks positioned at an early part of the binary data should be coded in comparison with no or few blocks. In this case the, a predetermined number of macroblocks positioned at the early part of the compression frame are processed without compression as the exceptional data blocks. In FIG. 25, 16 exceptional data blocks (MB0 to MB 15) are assumed. In the beginning of the compression, the coder 640 processes the exceptional data blocks (MB0 to MB 15) (73 5) and stores the exceptional data blocks within the second secondary memory 125. The exceptional data block includes an exception handling flag, and the binary data and position of the exceptional data block are stored within the second secondary memory 125.

After processing the exceptional data blocks, a searcher 713 sets a searching range, loads the domain blocks belonging to the search range, compares the macroblocks, calculates the costs according to the distance information and difference value obtained in relation to the range block, and transfers the lowest cost value and a distance information on the domain block generating the lowest cost to the coder 640.

The coder 640 compares the binary data of the range block and the domain block and determines whether the binary data are identical with each other (cost=0) (S715). The binary data of the rang block and the domain block are identical with each other, the searcher 620 encodes the binary data of the range block with the distance information and the difference flag to generate the compressed data and buffers compressed data within the second secondary memory 125 (719). When the binary data of the range block and the binary data of the selected domain block are identical with each other, the coder 640 generates a compressed data of the range block represented by the distance information between the range block and the domain block.

When there is no domain block of which binary data is identical with that of the range block (cost≠0), the coder 640 checks the cost at step 721 and retrieves the global table using the cost at step 723. The cost is checked for determining whether the cost exists in the global table and/or local table. Next, the coder 640 checks whether the cost value exists in the global table at step 725. When the cost value exists in the global table, the coder 640 stores the distance information and difference information within the second secondary memory 125 at step 719. The distance information may include the distance flag and distance value of the range block relative to the corresponding domain block, and the difference information may include the cost value, i.e. the value stored within the global table. When the cost value does not exist in the global table, the coder 640 searches for the cost value in the local table at step 727 and determines whether the cost value exists in the local table at step 729. When the cost value exists in the local table, the coder 640 stores the distance information and the difference information within the second secondary memory 125 at step 719. When the cost value is not 0 and exists in the global table or the local table, the coder 640 encodes to compress the binary data of the range block with the distance and difference information obtained relative to the domain block and stores the compressed data within the second secondary memory 125.

When it is determined that the cost value does not exist in the local memory at step 729, the coder 640 activates the exception handler 650 such that the exception handler 650 generates an exception handling flag at step 731 and stores the binary data of the range block with the exception handling flag at step 733. When the range block is not identical with any of domain blocks in the searching range and the cost value does not exist in any of the global and local tables, the coder 640 stores the uncompressed binary data with the exception handling flag generated by the exception handler 650.

As described above, the coder 640 may store the binary data of the range block within the second secondary memory 125 without compression. For example, when the binary data of the short blocks constituting the range block are not found in any of the short blocks of the domain blocks of the searching range or the cost of the short block of which binary data are determined to be identical with those of any of the short block of the range block is high, the range block is handled as an exceptional data block. When the compression cost of the range block is greater than a predetermined threshold value (i.e. the cost value does not exist in the global and local tables), the binary data of the range block is stored without being compressed. In this case, the coder 640 notifies the exceptional data block to the exception handler 650 such that the exception handler 650 stores the binary data of the range block within the secondary memory 120. The exception handler 650 can be integrated into the coder 640.

The compressor 460 repeats the compression operation as above described and stores the compressed binary data of the range blocks within the second secondary memory 125. The compressed data stored within the second secondary memory 125 may include the distance information, difference information, and exceptional data blocks. The compressed data stored within the second secondary memory 125 can be expressed as Table 2.

**Table 2**

| Secondary memory | Remarks |
|---|---|
| Distance information | -store domain block with distance value if distance flag=1 -do not store distance value if distance flag=0 |
| Difference information | -store index of table if difference flag=1 and difference value exist in table -do not store if difference value=0 |
| Exceptional data block | -store binary data with exception handling flag |

As described above, the searcher 620 and the coder 640 perform indexing the first domain block to the domain block at which the sum of the costs is lowest that are positioned prior to the range block in the searching range, compares the binary data of the indexed domain blocks with the binary data of the range block, and compresses the range block on the basis of the compression result. In FIG. 24, since the distance between the range block and the third domain block in the searching range is 0, the coder 640 generates the distance and difference values obtained in relation to the third domain block [4,5] as the compressed data.

In the meantime, in a case that the domain blocks such as the first domain block [6,7] and fifth domain block [2,3] that have no short block identical with the short blocks of the range block, the sum of the costs become greater than the coding threshold value. In a case that the short blocks of all the domain blocks in the search range are not identical with the short blocks of the range block, i.e. when the sum of the cost exceeds the threshold value, the coder 640 regards the range block as the exceptional data block.

In the domain block of which one short block is identical with one of the short blocks constituting the range block, such as second domain block [5,6], fourth domain block [3,4], sixth domain block [1,2], and seventh domain block [0,1], the sum of the costs is less than the coding threshold value. With such blocks, the coder 640 calculates the sum of the costs obtained between the range block and the respective domain blocks and determines the distance and difference values obtained relative to the domain block which gives the lowest cost sum as the compressed data. In a case that the coder 640 is provided with the global table and/or local table, the coder 640 matches the difference value to an index so as to retrieve the information indicated by the index within the table as the data and stores the index. In this case, the compressed data of the range block may include the distance information relative to the corresponding domain block and the table information.

In the above descriptions, the threshold value of the cost can be changed. In a case that the block has a length of 16 bits, when the cost is greater than 65536, the block is regarded as an exceptional data block so as to skip compression, and otherwise, a compression process is applied.

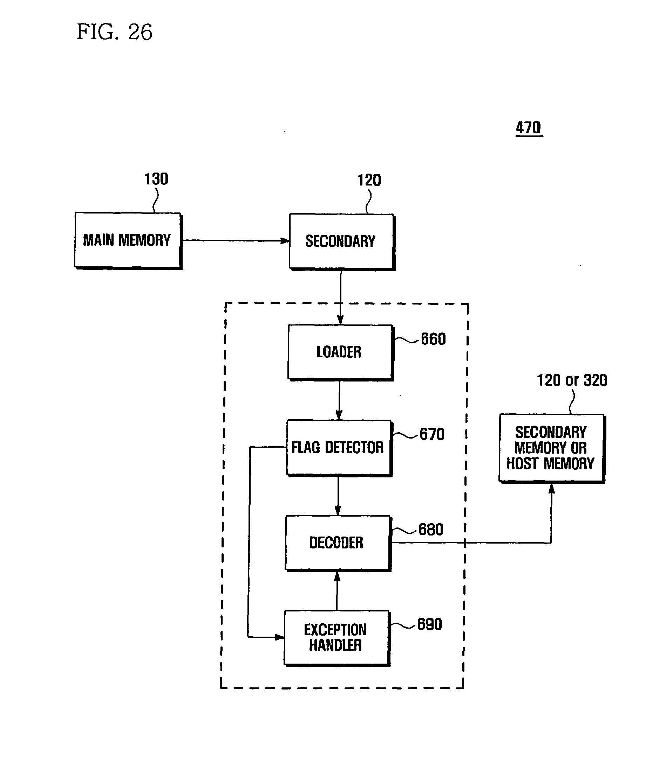

FIG. 26 is a block diagram illustrating a configuration of a decompressor of a fusion memory device according to an exemplary embodiment of the present invention.

Referring to FIG. 26, the decompressor 470 includes a loader 660, a flag detector 670, a decoder 680, and an exception handler 690.

The loader 660 loads the compressed data read out from the secondary memory 120 and the global and local tables required for decompressing the compressed data at corresponding regions. The compressed data is composed of the distance information, difference information, and exceptional data block as shown in Table 2. The distance information is composed of the distance flag and distance value and the difference information is composed of the difference flag and cost value. The flag detector 670 detects the distance and difference information and transfers the detected information to the decoder 680. When the distance and difference information is received, the decoder 680 analyzes the distance information and determines the position of a domain block relative to the range block on the basis of the distance flag and distance value. The decoder 680 also determines the difference value between the range block and domain block on the basis of the difference flag and cost value. Consequently, the decoder 680 performs decoding on the compressed data to recover the range block through the XOR operation with the domain block. When an exception handling flag is detected at the flag detector 670, the decoder 680 activates the exception handler 690 such that the exception handler 690 handles the data of the range block. In this case, the exception handler 690 outputs the range block as it is. Although the exception handler 690 is depicted as a separate element in FIG. 26, the exception handler 690 can be incorporated into the decoder 680. The decompressed data are buffered within the secondary memory 120 and read out from the secondary memory 120 and then written within the host memory 320 by the host controller 310.

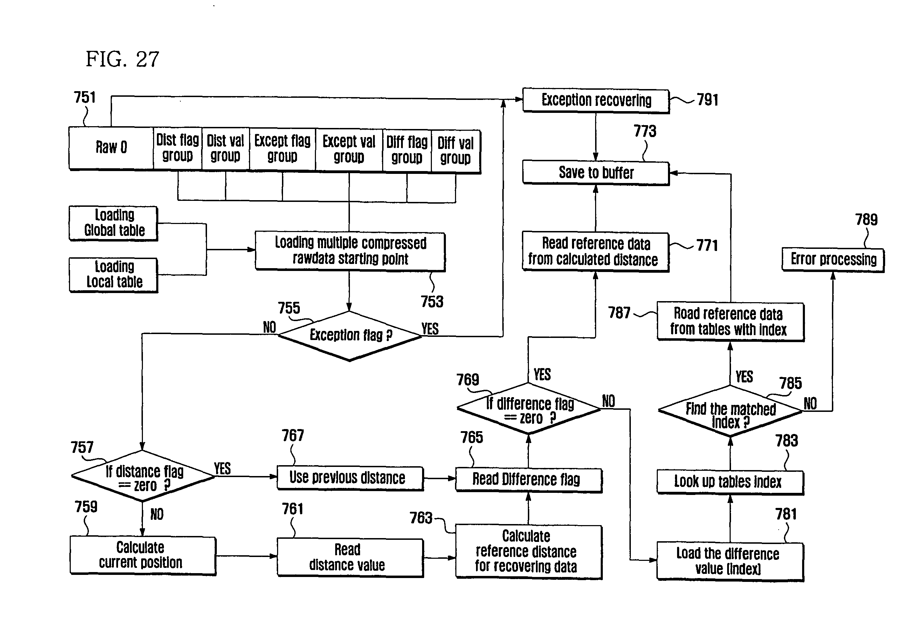

FIG. 27 is a flowchart illustrating a decompression operation of the decoder 680 of FIG. 26.

In FIG. 27, a compressed data 751 read out from the main memory 130 and stored within the secondary memory 120 are exceptional data blocks, i.e. a predetermined number of the macroblocks positing at the early part of a compression frame. In this case, the decoder 680 activates the exception handler 690 to recover the exceptional data blocks at step 791 and stores the recovered data within the second secondary memory 125 at step 773. Next, the decoder 680 performs decompression on the compressed data to recover the binary data at step 751. To recover the binary data, the decoder 680 analyzes the distance information, determines the position of the domain block on the basis of the analysis result, search refers to a table, and recover the binary data of the range block with reference to the table. The binary data of the exceptional data block is recovered by checking the position of the exceptional data block and placing the exceptional data block at the position.

In this embodiment, the exceptional data blocks are recovered at first and then the compressed data of the range blocks are decompressed on the basis of the distance information and difference information, However, the compressed data recovery procedure can proceed to decompress the compressed range blocks and then recover the exceptional data blocks.

The decoder 680 loads the global and local tables used for compressing the binary data and checks a start point of the compression frame at step 753. Next, the decoder 680 checks whether an exception flag is set at step 755. When an exception flag is set, the decoder 680 checks the position of the exceptional data block and processes the exceptional data block at step 791 such that the recovered data are placed at the position of the range block within the second secondary memory 125. Repeating these operations, the binary data of the exceptional data block is recovered to be buffered within the second secondary memory 125.

After completely recovering the binary data of the exceptional data blocks, the decoder 680 checks the distance information and determines whether a distance flag is set at step 757. When a distance flag is set, the decoder 680 searches for a domain block at a position moved as much as the distance value. When it is determined that the same distance flag is set again, i.e., the distance value is not changed from the previous status, the decoder 680 does not move the search position.

In the case that the distance flag is set, the decoder 680 calculates the position of the current range block at step 759, checks the distance value of the distance information at step 761, and selects a domain block located at a block position distant as much as the distance value from the current range block at step 763. In the case that the distance flag is reset, the decoder 680 selects a block distant as much as the distance value calculated for the previously recovered range block at step 757. The decoder 680 checks the distance information and selects, when the distance flag is set, the domain block distant as much as the distance value from the current range block as the reference domain block and selects, when the distance flag is reset, a reference domain block while maintaining the previous distance value.

After selecting the reference domain block using the distance information, the decoder 680 reads the difference flag at step 765 and checks the status of the difference flag. When it is determined that the difference flag is reset, the decoder reads the binary data of the reference domain block for the binary data of the range block at step 771 and stores the binary data within the second secondary memory 125. The reset status of the difference flag means that the binary data of the range block and the reference domain block are identical with each other. Accordingly, the decoder 680 recovers the binary data of the range block by copying the binary data of the reference domain block.

When it is determined that the different flag is set, the decoder 680 reads the difference value of the difference information at step 781. The difference value can be a cost value generated in the compression process, and the cost value can be an index of the global table or local table. Accordingly, the decoder 680 loads the difference value as an index of the table at step 781 and looks up the index in the cost tables at step 783. The cost value (index) is searched in the global table at first and then, when the index is not retrieved in the global table, in the local table. During the table look-up, the decoder 680 determines whether the index matched the cost value is found at step 785. When the index matched the cost value is found, the decoder 680 reads reference data from the table with the index so as to recover the range block at step 787 and stores the recovered data within the secondary memory 120 at step 773. When the index matching the cost is not found in the tables, the decoder 680 performs error processing. As described above, when the difference flag is set, the decoder 680 uses the cost value of the difference information as the index of the table and reads the data indicated by the index for recovering the binary data of the range block through the XOR operation with the domain block.

By repeating these operations, the binary data of the compressed range blocks are recovered on the basis of the distance information and difference information. In summary, the binary data of the compressed range block is recovered by checking the distance and difference information, and selecting a reference domain block on the basis of the distance information, and processing the binary data of the reference domain block on the basis of the difference information.

The binary data (code and user data) read and write operations of the fusion memory according to an exemplary embodiment of the present invention are described hereinafter in more detail. In the following descriptions, it is assumed that the compressor and decompressor are structured as shown in FIGS. 18 and 27. The secondary memory 120 includes a first and second secondary memories 123 and 125, and the second secondary memory 125 can be used as a buffer of the compressor 460 and decompressor 470.

In a binary data writing mode, the binary data downloaded from the host controller 310 is buffered within the second secondary memory 125 in unit of compression frame under the control of the core controller 410. The compressor 460 extracts the binary data of the range block from the buffered data, defines the domain blocks, calculates the distance information and difference information on the domain blocks, generates compressed data using the distance and difference information obtained relative to the domain block which gives the lowest cost, and buffers the compressed data within the first secondary memory 123 (or the internal buffer of the core controller 410). The core controller 410 writes the buffered compressed data within a specific region of the main memory 130 via the NAND interface. In the following description, it is assumed that the compressed data are buffered within the first secondary memory 123.

In a binary data reading mode, the core controller 410 reads out the compressed data from a corresponding area of the main memory 130 such that the compressed data are stored within the second secondary memory 125. At this time, the decompressor 470 analyzes the distance and difference information of the compressed data buffered within the second secondary memory 125 and selects a domain block on the basis of the distance and different information and recovers the original binary data on the basis of the difference value obtained in relation with the selected domain block. When the compressed data is a code written in the pseudo NOR mapping area 133 of the main memory 130, the code decompressed by the decompressor 460 is buffered within the first secondary memory 123 such that the host controller 310 reads out the code. When the compressed data is a code or user data written in the RAM mapping area or the user mapping area, the core controller 410 notifies the data type to the host controller 310 such that the host controller 310 reads the decompressed code or data via the NAND interface and stores the decompressed code or user data within the host memory 320.

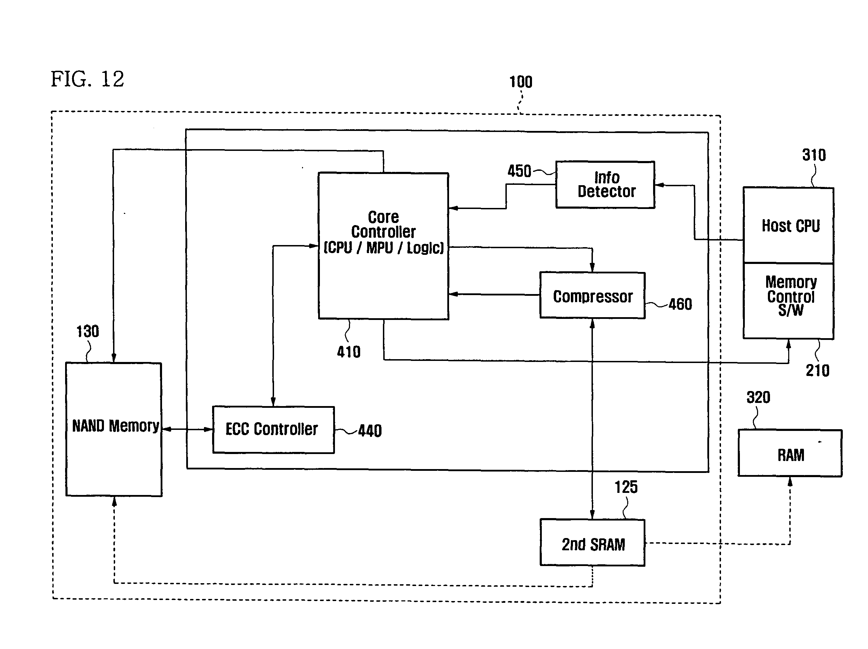

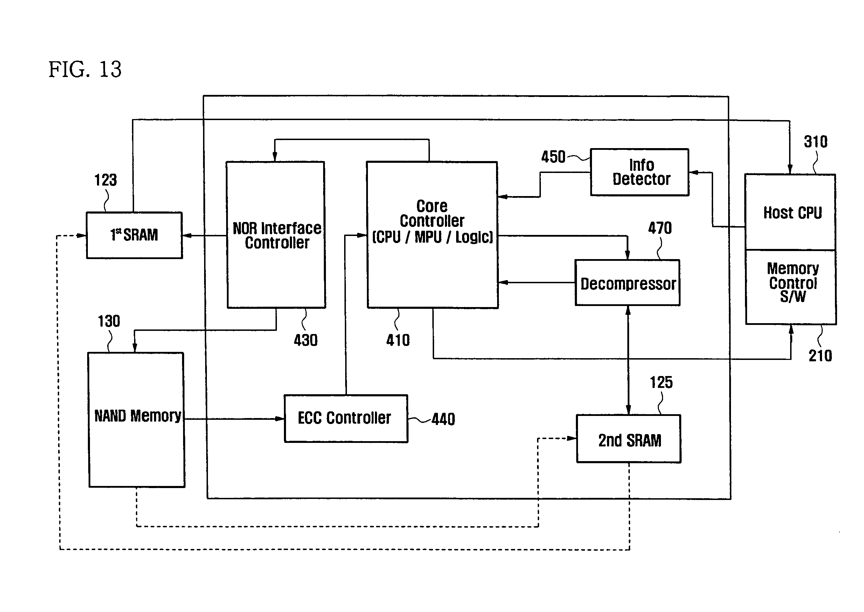

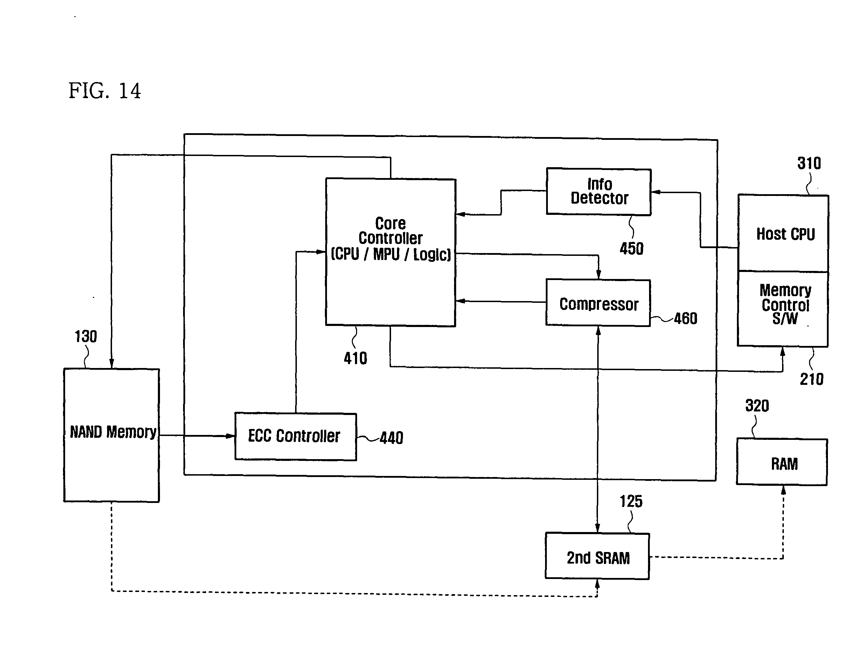

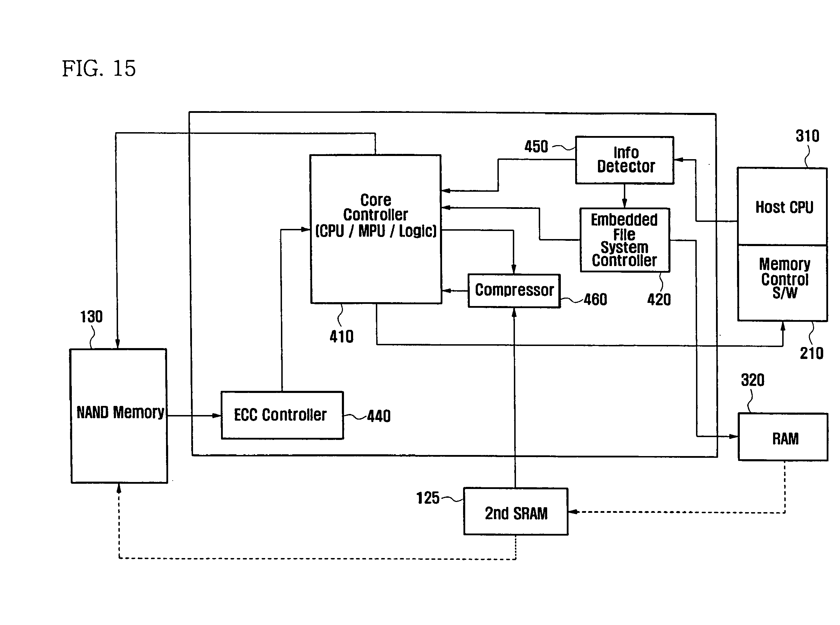

FIG. 12 is a block diagram illustrating how a code is stored within the system data region of the main memory of a fusion memory device according to an exemplary embodiment of the present invention, FIG. 13 is a block diagram illustrating how a code is read from the pseudo NOR mapping area of the main memory of a fusion memory device according to an exemplary embodiment of the present invention, FIG. 14 is a block diagram illustrating how a code is read out from the RAM mapping area of the main memory of a fusion memory device according to an exemplary embodiment of the present invention, FIG. 15 is a block diagram illustrating how a user data is written within the user data region of the main memory of a fusion memory device according to an exemplary embodiment of the present invention, and FIG. 16 is a block diagram illustrating how a user data is read out from the user data region of the main memory of a fusion memory device according to an exemplary embodiment of the present invention.

Referring to FIG. 12, a code writing operation of the fusion memory device is described hereinafter. The host device 300 and the fusion memory device 100 are configured as shown in FIG. 6.

When control information for writing the code is generated by the memory control software 210 of the host controller 310, the information detector 450 extracts an address and compression flag from the control information and transfers the extracted address and compression flag to the core controller 410. When the address and compression flag are received, the core controller 410 controls to set the compressor 460 with a compression scheme appropriated for the code. The compressor can be configured as shown in FIG. 21 or FIG. 23. The code read out from the host memory 320 is buffered within the second secondary memory 125 under the control of the host controller 310.

The code can be a program (including firmware and software) of the host device 300 and store within the pseudo NOR mapping area 133 and/or the RAM mapping area 135. As shown in FIG. 6, the host controller 310 predetermines, in the code writing mode, the address of the pseudo NOR mapping area 133 and/or the RAM mapping area 135 for storing the code and transfers the address to the fusion memory 100 with the code.

The code transmitted by the host controller 310 is buffered within the second secondary memory 125. The buffered code is provided to the compressor 460 in unit of compression frame. The compressor 460 performs compression on the code read out from the second secondary memory 125. The compressor 460 loads the code of a range block to be compressed, determines a searching range, examines the domain blocks arranged in the searching range in the forward and backward directions. The compressor 460 compares the range block with the respective domain blocks arranged in the searching range and calculates the distances and differences between the range block and the respective domain blocks; generates compressed data using the distance and difference obtained relative to the domain block which results in the lowest cost; and stores the compressed data within the first secondary memory 123. By repeating these operations, the compressor 460 loads the range block code, compares the range block and the domain blocks arranged in the searching range, calculates the distances and differences between the range block and the respective domain blocks, generates the compressed data using the distance and difference obtained relative to the domain block which results in the lowest cost, and stores the compressed data within the first secondary memory 123. The compressor 460 can be implemented with a global table and/or a local table. In this case, the compressor 460 translates the differences into the cost values that are used as table indexes.

The compressed data buffered within the first secondary memory 123 are read out to be stored within the corresponding area of the main memory 130 under the control of the core controller 410. The core controller 410 assigns an address for the pseudo NOR mapping area 133 or the RAM mapping area 135 of the main memory 130 and writes the compressed code read out from the first secondary memory 123 within the area corresponding to the address via NAND interface. When the compressed code is written in the main memory 130, the ECC controller 440 accesses the ECC information in the main memory 130 and determines whether the compressed code is normally stored. When it is determined that the compressed code is normally stored, the ECC controller 440 notifies the normal storage result to the core controller 410, and the core controller 410 forwards the normal storage result to the host controller 310.

Upon receiving the normal storage result, the host controller 310 transfers the next code to be compressed to the fusion memory device 100. The core controller 410 controls such that the code received from the host controller 310 within the second secondary memory 125 and controls the compressor 460 to compress the code read out from the second secondary memory 125. The compressed code is written within the corresponding area of the main memory under the control of the core controller 410. By repeating these operations, the memory controller 110 of the fusion memory device 100 compresses the codes transmitted by the host device 300 and stores with the system data region of the main memory 130 via the NAND interface.

Referring to FIG. 13, an operation of reading a code from the pseudo NOR mapping area 133 of the main memory 130 is described hereinafter. The host device 300 and the fusion memory device 100 are configured as shown in FIG. 7.

When control information for reading the code stored within the pseudo NOR mapping area 133 is received from the host controller 310, the information detector 450 extracts an address and compression flag from the control information and transfers the address and compression flag to the core controller 410. When the address and compression flag are received, the core controller 410 transmits the address to the NOR interface controller 430 for reading the code stored within the pseudo NOR mapping area 133. Upon receiving the address, the NOR interface controller 430 maps the address to a position of the code within the pseudo NOR mapping area 133 and generates a command for reading the code. The ECC controller 440 reads the ECC from the main memory 130 to generate ECC information and determines whether there is no error. When there is no error, the ECC controller 440 notifies the result to the core controller 410. The core controller 410 sets the decompressor 470 with a decompression scheme for decompressing the compressed code and controls such that the compressed code read out from the pseudo NOR mapping area 133 of the main memory 130 is buffered within the second secondary memory 125. Accordingly, the decompressor 470 configured as shown in FIG. 21 or FIG. 26 analyzes the distance and difference information on the compressed range block and performs decoding to recover the code on the basis of the information. The compression code of the range block can be the distance and difference relative to the reference domain block. In this case, the decompressor 470 finds the reference domain block for decoding the range block on the basis of the distance flag and distance value and decompresses the compressed range block with reference to the domain block such that the decompressed code is buffered within the first secondary memory 123. The recovered code buffered within the first secondary memory 123 is rearranged in byte such that the host controller 310 can read the code via the NOR interface. In this manner, the codes of the range blocks are recovered. When the decompression on the buffered code is completed (i.e. the compressed code of the compression frame size are entirely recovered), the decompressor 470 notifies the core controller 410 of the complete decompression and then the core controller 410 notifies the host controller 310 of the complete decompression such that the host controller 310 reads the code from the first secondary memory 123 via NOR interface.

When it is notified that the decompression is successfully completed, the core controller 410 notifies the NOR interface controller 430 of the complete decompression such that the NOR interface controller 430 reads the compressed code stored within the pseudo NOR mapping area 133 of the main memory 130 and buffers the code within the second secondary memory 125. The decompressor 460 decompresses the compressed code buffered within the second secondary memory 125. The core controller 410 reads the decompressed code from the second secondary memory 125 and writes the code within the first secondary memory 123, and the NOR interface controller 430 converts the address of the code buffered within the first secondary memory 123 into other type of address such that the host controller 310 can read the code via the NOR interface. The host controller 310 reads and processes the code from the first secondary memory 123.

By repeating these operations, the fusion memory device 100 recovers the code read out from the pseudo NOR mapping area 133 of the main memory 130, converts the address of the code such that the host device 300 reads and processes the code at the converted address.

Referring to FIG. 14, a code reading operation within the RAM mapping area 135 of the main memory 130 is described hereinafter. The host device 300 and the fusion memory device 100 are configured as shown in FIG. 8.

When control information for reading the code stored within the RAM mapping area 135 of the main memory 130 is received from the host controller 310, the information detector 450 extracts an address and compression flag from the control information and transfers the address and compression flag to the core controller 410. When the address and compression flag are received, the core controller 410 checks a position of the RAM mapping area 135, at which the code is stored, with reference to the address and generates a command for reading the code. At this time, the ECC controller 440 reads the ECC from the main memory 130 to generate the ECC information and determines whether the code has been errorlessly stored. When it is determined that the code has been stored errorlessly, the ECC controller 440 notifies the core controller 410 of the errorless storage.

When it is determined that the code is errorless, the core controller 410 sets the decompressor 470 with a decompression scheme and reads the code stored from the RAM mapping area 135 of the main memory 130 and writes the code within the second secondary memory 125. The decompressor 470, configured as in FIGS. 21 and 26, analyzes the distance and difference information of the compressed range block and decompresses the range block with reference to the distance and difference information. The procedure for recovering the code stored within the RAM mapping region 135 of the main memory 130 can be performed as the procedure described with reference to the FIG. 13. After the code being recovered, the decompressor 470 notifies the core controller 410 of the code recovery, and the core controller 410 notifies the same to the host controller 310 such that the host controller 310 reads the decompressed code via the NAND interface and stores the code within the host memory 320.

By repeating these operations, the fusion memory device 100 decompresses the compressed code stored within the RAM mapping area 135 of the main memory 130 and processes the code to be read by the host device 300.

Referring to FIG. 15, a user data writing operation within the user data region 137 of the main memory 130 is descried hereinafter. The host device 300 and the fusion memory device 100 are configured as shown in FIG. 9.

When control information for writing the user data within the user data region 137 of the main memory 130 is received from the host controller 310, the information detector 450 extracts an address and compression flag from the control information and transfers the address and compression flag to the file system controller 420. When the address and compression flag are received, the file system controller 420 forwards with address and compression flag to the core controller 410, and the core controller 410 sets the compressor 460 with a compression scheme on the basis of the compression flag. The file system controller 420 also reads out the user data from the host memory 320 and writes the user data within the second secondary memory 125. The user data are stored within the second secondary memory 125 after being processed to be fit for a specific file system (for example, a File Allocation Table (FAT)).

After being buffered within the second secondary memory 125, the user data is compressed by the compressor 460 and read out to be buffered within the first secondary memory 123, and the compressor 460 notifies the core controller 410 of the compression result. The user data compression process can be performed in the same manner as in the code compression process in FIG. 12. Upon receiving the compression result, the core controller 410 designates an address of the user data region 137 of the main memory 130 such that the compressed user data is read out from the first secondary memory 123 to be stored within the user data region 137 via the NAND interface. After the user data being stored within the main memory 130, the ECC controller 440 accesses check the ECC information stored within the main memory 130 and determines whether the user data is successfully stored. When it is determined that the user data is successfully stored, the ECC controller 440 notifies the core controller 410 of the successful storage result such that the core controller 410 notifies the successful storage result to the host controller 310.

By repeating these operations, the main memory controller 110 of the fusion memory device 100 compresses the user data downloaded from the host device and writes the compressed user data within the user data region 137 of the main memory 130.

Referring to FIG. 16, a user data reading operation within the user data region 137 of the main memory 130 is described hereinafter. The host device 300 and the fusion memory device 100 are configured as shown in FIG. 9.

When control information for reading the user data from the user data region 137 of the main memory 130 is received from the host controller 310, the information detector 450 extracts an address and compression flag from the control information and transfers the address and compression flag to the file system controller 420. When the address and compression flag are received, the file system controller 420 forwards the address and compression flag to the core controller 410, and the core controller 410 maps the address to a position of the user data region 137 at which the target user data is stored and generates a command for reading the user data. At this time, the ECC controller 440 generates an ECC information by reading the ECC from the main memory 130 and determines whether the target user data has been normally stored on the basis of the ECC information. When it is determined that the target user data has been normally stored, the ECC controller 440 notifies the core controller 410 that the user data is normally stored, such that the core controller 410 sets the decompressor 470 with a decompression scheme and controls the decompressor 470 to decompress the user data read out from the user data region 137 of the main memory 130 to be buffered within the second secondary memory 125, and notifies the decompression result to the core controller 410. The decompression scheme used for recovering the user data can be identical with that used for recovering the code as shown in FIG. 14. After the user data being recovered, the file system controller 420 controls such that the user data is stored within the host memory 320.. The compressor and decompressor may be composed of hardware logic, and the fusion memory 100 may be composed of a single memory chip.

While the invention has been shown and described with reference to a certain preferred embodiment thereof, it will be understood by those skilled in the art that various changes in form and details may be made therein without departing from the spirit and scope of the invention as defined by the appended claims.

As described above, the fusion memory device of the present invention is advantageous for efficient storage management since the binary data are stored in a compressed data format. Also, the fusion memory device of the present invention is advantageous to efficiently manage reading/writing operations for different types of binary data by providing a system data region and user data region that are, respectively, accessed via NOR interface and NAND interface.

## Claims

1. A fusion memory device comprising:
a main memory for storing data in a compressed format;
a secondary memory for buffering data to be written within and read from the main memory; and
a memory controller having a compressor and decompressor pair, the memory controller buffering downloaded data within the secondary memory and compressing the data buffered in the secondary memory through use of the compressor, and buffering, in a reading mode, the data read out from the main memory within the secondary memory and decompressing data buffered within the secondary memory through use of the decompressor.

2. The fusion memory device of claim 1, wherein the compressor comprises:
a searcher for examining a plurality of domain blocks in a searching range and selecting one of domain blocks;
a comparator for generating a difference value by comparing data of the selected domain block and data of a range block to be compressed and updating the difference value when a lowest difference value is obtained between the range block and another domain block; and
a coder for encoding the range block to be compressed into distance information and difference information obtained relative to the domain block which gives the lowest difference value, the range block being a data block to be compressed and the domain block being a reference data block to be referred to for compressing and decompressing the range block.

3. The fusion memory device of claim 2, wherein the distance information comprises a distance flag and a distance value representing a number of blocks counted from the range block to the domain block, and the difference information comprises a difference flag for indicating identity between the range block and the selected domain block and a difference value for indicating a difference level between the range block and the selected domain block when two blocks are not identical with each other.

4. The fusion memory device of claim 3, wherein each of the range blocks and the domain blocks comprises at least two short blocks, and the coder sets the difference flag to 0 when the short blocks of the range block and the domain block are identical with each other, and to 1 and performs entropy coding on the difference value when the short blocks of the range block and the domain block differ from each other.

5. The fusion memory device of claim 2, wherein the compressor further comprises an exception handler for performing an exception handling on the range block to output the range block as the compressed data with an exception handling flag when no domain block of which short blocks are identical with the short blocks of the range block exists in the searching range.

6. The fusion memory device of claim 3, wherein the decompressor comprises:
a flag detector for detecting the distance flag and difference flag from the compressed data; and
a decoder for checking the distance value in accordance with the detected distance flag, selecting a domain block with reference to the distance value, checking the difference flag of the selected domain block, and recovering the data of the range block by copying the data of the selected domain block when the difference flag indicates the identity of the range block and the selected domain block, and by performing an exclusive-or (XOR) operation with the difference value.

7. The fusion memory device of claim 4, wherein the decompressor comprises:
a flag detector for detecting the distance flag and difference flag from the compressed data; and
a decoder for selecting a domain block on the basis of the distance flag and the distance value, and recovering the short blocks of the range block by copying the short blocks of the domain block when the difference flag is set to 0, or by performing an exclusive-or (XOR) operation on the short blocks of the domain block with the difference value when the difference flag is not set to 0.

8. The fusion memory device of claim 5, wherein the decompressor comprises:
a flag detector for detecting the exception handling flag, the distance flag, and the difference flag from the compressed data; and
a decoder for recovering the range block with original data when the exception handling flag is detected, selecting a domain block on the basis of the distance flag and distance value when the exception handling flag is not detected, and recovering the short blocks of the range block by copying the short blocks of the domain block when the difference flag is set to 0, or by performing an exclusive-or (XOR) operation on the short blocks of the domain block with the difference value when the difference flag is not set to 0.

9. The fusion memory device of claim 2, wherein the compressor further comprises:
a cost table for storing cost values corresponding to differences between the blocks; and
a global table for storing the difference values of the blocks corresponding to the cost values;
wherein the searcher generates difference values by comparing the data of the domain blocks and the range block, and generates a cost with reference to the difference values in the cost table; and
wherein the coder encodes the distance and difference information obtained relative to the domain block of the compressed data.

10. The fusion memory device of claim 9, wherein the searcher generates distance information including a distance flag and a distance value representing a number of blocks counted from the range block to the domain block and a cost representing a difference value calculated between the range block and the domain block.

11. The fusion memory device of claim 10, wherein each of the range blocks and the domain blocks comprises at least two short blocks, and the searcher examines the domain blocks arranged in the searching range, generates the difference value by comparing the range block and each domain block in units of short blocks as searching in a forward direction, generates a cost using the difference with reference to the cost table, and updates the distance information and the cost when the currently generated cost is less than the previous cost for obtaining the distance information and a cost relative to the domain block which gives a lowest cost.

12. The fusion memory device of claim 10, wherein each of the range blocks and the domain blocks comprises at least two short blocks, and wherein the searcher comprises:
a searching range setting unit for setting the searching range;
a range block selector for selecting a range block;
a domain block selector for selecting a reference domain block in the searching range;
a comparator for generating a difference value by performing an exclusive or (XOR) operation between the range block and the reference domain block;
a distance calculator for generating the distance information including the distance flag and distance value by calculating the distance between the range block and the reference domain block;
a cost calculator for calculating a cost matching a difference value generated by the comparator with reference to the cost table; and
an output unit for outputting the cost and the distance information to the coder.

13. The fusion memory device of claim 12, wherein the coder generates a compressed data using the distance information and distance flag output by the searcher when the cost is 0, and using the distance information and index of the global table when the cost is not 0.

14. The fusion memory device of claim 13, wherein the coder further comprises an exception handler for generating the range block with an exception handling flag as the compressed data of the range block when an identical cost is not retrieved in the tables.

15. The fusion memory device of claim 9, wherein the compressor further comprises a local table; and the coder searches for the cost in the local table when the cost is not retrieved in the global table, generates the distance information and an index of the local table as compressed data when the cost is retrieved in the local table, the local table being generated with costs of the difference values frequently appearing during compression but not included in the global table.

16. The fusion memory device of claim 9, wherein the decompressor comprises:
a flag detector for detecting a distance flag and a difference flag from the compressed data; and
a decoder for selecting a domain block on the basis of the distance flag and a distance value, finding a difference value matching the cost in the global table, and recovering the short blocks of the range block by an operation on the data of the domain block with the difference value.

17. The fusion memory device of claim 13, wherein the decompressor comprises:
a flag detector for detecting the distance flag and the difference flag from the compressed data; and
a decoder for recovering the range block, by finding a reference domain block on the basis of the distance flag and the distance value, recovering a short block of the range block whose cost is 0 by copying a corresponding short block of the reference domain block, and recovering a short block of the range block whose cost is not 0 by performing an exclusive or (XOR) operation on the corresponding short block of the reference domain block with a difference value matching the cost retrieved in the global table.

18. The fusion memory device of claim 14, wherein the decompressor comprises:
a flag detector for detecting the exception handling flag, the distance flag, and the difference flag from the compressed data; and
a decoder for recovering the range block with original data when the exception handling flag is detected, selecting a domain block on the basis of the distance flag and distance value when the exception handling flag is not detected, and recovering the short blocks of the range block by copying the short blocks of the domain block when the difference flag is set to 0, or by performing an exclusive-or (XOR) operation on the short blocks of the domain block with the difference value when the difference flag is not set to 0.

19. A fusion memory device comprising:
a main memory including a pseudo NOR mapping area and a host memory mapping area;
a secondary memory for buffering data to be written into or read out from the main memory; and
a memory controller for controlling, in a writing mode, reading out data downloaded from the secondary memory and writing the read data within the main memory via a NAND interface and, in a reading mode, reading out the data from the main memory, wherein the data stored within the host mapping region of the main memory is read out via the NAND interface, and the data stored within the pseudo NOR mapping area is read out via the NAND interface and buffered within the secondary memory with an address converted for the host device to read out the buffered data from the secondary memory via a NOR interface.

20. The fusion memory device of claim 19, wherein the memory controller comprises:
an information detector detecting control information transmitted by a host device and extracting a control command and an address;
a core controller for controlling, when the control command is a writing command, writing data downloaded from the host device at a position of the main memory corresponding to the address via the NAND interface, and controlling, when the control command is a reading command, checking a pseudo NOR or a host memory mapping area of the main memory with the address and performing a writing operation according to the pseudo NOR or the host memory mapping area, wherein the core controller notifies, when the data are completely buffered in the secondary memory when the mapping area is the pseudo mapping area and reads out the data from a corresponding area of the main memory when the mapping area is the host memory mapping area via the NAND interface; and
an NOR interface controller for converting the address of the data read via the pseudo NOR mapping area to be an address accessed by the host device via the NOR interface.

21. A fusion memory device comprising:
a main memory including a pseudo NOR mapping area and a host memory mapping area for storing data compressed depending on data types;
a secondary memory for buffering data to be written within or read out from the main memory; and
a memory controller including a compressor and decompressor pair, the memory controller controlling, in a writing mode, buffering data downloaded within the secondary memory, compressing the buffered data through use of the compressor, and writing the compressed data with a corresponding mapping area of the main memory via a NAND interface; and controlling, in a reading mode, reading out the data from the main memory via the NAND interface and buffering the read data within the secondary memory, recovering the data from a compressed format through use of the decompressor, outputting the data derived from the host memory mapping area to a host interface via the NAND interface, converting an address of the data derived from the pseudo NOR mapping area for allowing NOR interface access, and buffering the data within the secondary memory with the converted address such that a host device can read out the data from the secondary memory via the NOR interface.

22. The fusion memory device of claim 21, wherein the compressor comprises:
a cost table for storing costs corresponding to differences between blocks containing the data;
a global table for storing difference values matching the costs;
a searcher for examining domain blocks in a searching range, generating difference values by comparing the data of the domain blocks and a range block, and generating cost with reference to the difference values in the cost table; and
a coder for encoding distance and difference information obtained relative to a reference domain block to be generated as the compressed data, the range block being a data block to be compressed, and the domain block being a reference data block to be referred to for compressing and decompressing the range block.

23. The fusion memory device of claim 22, wherein each of the range blocks and the domain blocks comprise at least two short blocks, and the searcher examines the domain blocks arranged in the searching range, generates the difference value by comparing the range block and each domain block in units of short blocks as searching in a forward direction, generates a cost using the difference with reference to the cost table, and updates the distance information and cost when the currently generated cost is less than the previous cost for obtaining the distance information and cost relative to the domain block which gives the lowest cost.

24. The fusion memory device of claim 23, wherein the coder generates the distance information and resets a distance flag output by the searcher as the compressed data when the cost is 0 and generates the distance information and an index of the global table as the compressed data when the cost is not 0.

25. The fusion memory device of claim 22, wherein the secondary memory comprises a first secondary memory and a second secondary memory, and the memory controller further comprises an information detector and a core controller,
wherein, in the writing mode, the information detector extracts address information from control information transmitted by the host device; and the core controller controls buffering data downloaded from the host device within the second secondary memory, compressing the data buffered within the second secondary memory, buffering the compressed data within the first secondary memory, and writing the compressed data read out from the first secondary memory within a corresponding mapping area of the main memory via the NAND interface.

26. A method for accessing a fusion memory device including a main memory and a secondary memory for buffering data to be read from and written to the main memory, comprising:
buffering data downloaded from a host device within the secondary memory in a writing mode;
compressing the data;
writing the compressed data read out from the secondary memory within the main memory;
buffering the compressed data read out from the main memory within the secondary memory in a reading mode;
decompressing the compressed data; and
outputting the data read out from the secondary memory to a host device.

27. The method of claim 26, wherein compressing the data comprises:
examining the data buffered within the secondary memory in units of domain blocks in a searching range for finding a domain block whose data are identical with or most similar to the data of a range block;
comparing the data of the range block and respective domain blocks;
determining the domain block generating a least difference value relative to the range block as a reference domain block; and
encoding distance information and difference information calculated between the range block and the reference domain block as the compressed data of the range block, the range block being a data block to be compressed, and the domain block being a reference data block to be referred to for compressing and decompressing the data of the range block.

28. The method of claim 27, wherein the distance information comprises a distance flag and a distance value representing a number of blocks between the range block and the reference domain block, and the difference information comprises a difference flag indicating an identity between the range block and the reference domain block and a difference value indicating a similarity between the range block and the reference domain block when the data of the range block and the reference domain block are not identical with each other.

29. The method of claim 28, wherein each of the range blocks and the domain blocks comprise at least two short blocks, and the difference flag is set to 0 when the short blocks of the range block and the domain block are identical with each other, and is set to 1 when the short blocks of the range block and the domain block differ from each other, the difference value being entropy-coded when the short blocks of the range block and the reference domain block differ from each other.

30. The method of claim 28, wherein encoding distance information and difference information comprises attaching an exception flag to the range block, when no domain block of which at least one short block is identical with at least one short block of the range block is found in the searching range.

31. The method of claim 28, wherein decompressing the compressed data comprises:
extracting the distance flag and the distance value and the difference flag and the difference value from the compressed data;
finding the reference domain block on the basis of the distance value estimated by the distance flag;
determining whether the data of the range block and the reference domain block are identical with each other on the basis of the difference flag;
recovering the range block by copying the data of the reference domain block when the data of the range block and the reference domain block are identical with each other; and
recovering the range block by performing an exclusive or (XOR) operation on the data of the range block with the difference value when the data of the range block and the reference domain block are not identical with each other.

32. The method of claim 29, wherein decompressing the compressed data comprises:
extracting the distance flag and the distance value and the difference flag and the difference value from the compressed data;
determining the reference domain block on the basis of the distance flag and value;
determining whether the difference flag is set to 0;
recovering the short block of the range block by copying the corresponding short block of the reference domain block when the difference flag is set to 0; and
decoding the short block by performing an exclusive or (XOR) operation on the data of the short block with the difference value when the difference flag is not set to 0.

33. The method of claim 30, wherein decompressing the compressed data comprises:
extracting the exception handling flag, the distance flag, and the difference flag from the compressed data;
recovering the data of the range block from itself when the exception handling flag is extracted;
finding the reference domain block on the basis of the distance flag and the distance value when the exception handling flag is not extracted;
determining whether the difference flag is set to 0;
recovering the short block of the range block by copying the short block of the reference domain block when the difference flag is set to 0; and
recovering the short block of the range block by performing an exclusive or (XOR) operation on the data of the short block with the difference value when the difference flag is not set to 0.

34. The method of claim 28, wherein compressing the data comprises:
examining the data in units of domain blocks in the searching range of the data buffered within the secondary memory;
calculating difference values between the range block and the respective domain blocks;
finding a cost matching the least difference value in a cost table; and
encoding the distance information and the difference information obtained relative to a reference domain block with which the difference value is least as the compressed data, wherein the range block is a data block to be compressed and the domain block is a reference data block to be referred to for compressing and decompressing the data of the range block.

35. The method of claim 34, wherein examining the data comprises calculating a distance information including a distance value represented by a number of the blocks between the range block and the domain block and a distance flag.

36. The method of claim 35, wherein examining the data comprises finding the reference domain block having the least cost by repeatedly comparing the range block and the domain blocks.

37. The method of claim 36, wherein encoding the distance information and cost information comprises:
determining whether a cost is 0;
generating the distance information and a reset flag as the compressed data of the range block when the cost is 0;
retrieving the cost in a global table when the cost is not 0; and
generating an index of the global table and the distance information as the compressed data of the range block.

38. The method of claim 36, wherein each of the range blocks and the domain blocks comprise at least two short blocks, and encoding the distance and cost information comprises:
determining whether a cost of a short block of the range block is 0;
generating the distance information and resetting the distance flag as the compressed data of the range block when a cost of the short block of the range block is 0;
searching for the cost in a global table when a cost of the short block of the range block is not 0; and
generating an index of the global table and the distance information as the compressed data of the range block when the cost is found in the global table.

39. The method of claim 38, wherein encoding the distance information and the cost information further comprises:
searching for the cost in a local table when the cost is not found in the global table; and
generating the cost and the distance information mapped to the cost as the compressed data of the range block when the cost is found in the local table, the local table being generated by matching the difference values, frequently appearing during compression but not existing in the global table, with the costs.

40. The method of claim 38 and 39, wherein encoding the distance and the cost information further comprises;
designating the range block as an exception block when the cost is not found in the local table; and
encoding the data of the range block and an exception handling flag as compressed data of the range block.

41. The method of claim 33, wherein examining the data buffered within the secondary memory comprises:
defining the searching range;
selecting a range block;
selecting a domain block to be compared with the range block;
performing an exclusive or (XOR) operation between the range block and the domain block;
calculating a difference between the range block and the domain block;
finding a cost matching the difference in a cost table;
selecting, by repeating the above steps, the domain block having the lowest cost as a reference domain block to be referred to for compressing and decompressing the range block; and
outputting cost and distance information obtained between the range block and the reference domain block.

42. The method of claim 37, wherein decompressing the compressed data comprises:
extracting the distance flag and the difference flag from the compressed data;
finding the reference domain block on the basis of a distance value referred according to the difference flag;
obtaining the difference value matching the cost from the global table; and
recovering the range block by performing an operation between the data of the reference domain block and the difference value.

43. The method of claim 38, wherein decompressing the compressed data comprises:
extracting the distance flag and the difference flag from the compressed data;
finding the reference domain block on the basis of a distance value referred according to the difference flag;
determining whether the cost of the short block of the range block is 0;
recovering the short block by copying the corresponding short block of the reference domain block when the cost of the short block is 0;
retrieving a difference value matching the cost from the global table when the cost of the short block is not 0; and
recovering the short block by performing an exclusive or (XOR) operation between the short block and the retrieved difference value.

44. The method of claim 40, wherein decompressing the compressed data comprises:
extracting at least one of an exception handling flag, the distance flag, and the difference flag from the compressed data;
recovering the data of the range block as the decompressed range block when the exception handling flag is extracted;
finding the reference domain block with reference to the distance value set according to the distance flag when the exception handling flag is not extracted;
determining whether the cost of the short block of the range block is 0;
recovering the short block by copying the corresponding short block of the reference domain block when the cost of the short block is 0;
retrieving a difference value matching the cost from the global table when the cost of the short block is not 0; and
recovering the short block by performing an exclusive or (XOR) operation between the short block and the retrieved difference value.

45. A method for accessing a fusion memory device including a main memory having a pseudo NOR mapping area and a host memory mapping area and a secondary memory for buffering data to be read from and written to the main memory, comprising:
buffering, in a writing mode, downloaded data from a host device within the secondary memory;
writing the data read out from the secondary memory within the main memory via a NAND interface; and
reading out, in a reading mode, the data from the main memory to a host device, the data stored within the host memory mapping region being read out via the NAND interface, and the data stored within the pseudo NOR mapping area being read out via the NAND interface, an address of the data read out from the pseudo NOR mapping area being converted and buffered within the secondary memory with the data so as to be read out via a NOR interface with reference to the converted address.

46. The method of claim 45, wherein writing the data within the main memory comprises:
extracting address information from control information transmitted by the host device;
buffering data downloaded from the host device within the secondary memory with the address information; and
writing the data read out from the secondary memory within a mapping area of the main memory with reference to the address information via the NAND interface.

47. The method of claim 46, wherein reading out data from the main memory comprises:
extracting an address from control information received from the host device;
checking a mapping area of the main memory designated by the address;
reading, when the mapping area is the pseudo NOR mapping area, the data via the NAND interface, converting the address such that the host device accesses the data via the NOR interface with reference to the converted address, buffering the data within the secondary memory with the converted address, and notifying the host device of the buffered data; and
reading, when the mapping area is the host mapping area, the data via the NAND interface and outputting the data to the host device via the NAND interface.

48. A method for accessing a fusion memory device including a main memory having a pseudo NOR mapping area and a host memory mapping area and a secondary memory for buffering data to be read from and written to the main memory, comprising:
buffering, in a writing mode, downloaded data from a host device within the secondary memory, compressing the data, and writing the compressed data within one of the mapping areas of the main memory via a NAND interface; and
reading out, in a reading mode, compressed data from the main memory, buffering the compressed data within the secondary memory, decompressing the compressed data, determining whether the decompressed data is read out from the host memory mapping area, outputting, when the decompressed data is read out from the host memory mapping area, the decompressed data via the NAND interface, determining, when the decompressed data is read out from the pseudo NOR mapping area and converting, when the decompressed data is read out from the pseudo NOR mapping area, an address of the decompressed data into a NOR interface accessible address, and outputting the NOR interface accessible address.

49. The method of claim 48, wherein compressing the data comprises:
examining the data in units of domain blocks in searching range;
calculating a difference value between a range block and respective domain blocks;
retrieving a cost matching the difference value in a cost table; and
encoding distance information and difference information corresponding to the retrieved cost as a compressed data of the range block,
wherein the range block is a data block to be compressed, the domain block is a data block to be referred to for compressing and decompressing the range block, and the cost table is a table listing costs matching differences between blocks.

50. The method of claim 48, wherein the secondary memory comprises first and second secondary memories, and buffering the data comprises:
extracting, in a writing mode, an address from control information transmitted by a host device;
buffering data downloaded from the host device within the second secondary memory;
compressing the data;
buffering the compressed data within the first secondary memory; and
writing the compressed data within a corresponding mapping area of the main memory with reference to the address.
